**Europäisches Patentamt**

**European Patent Office**

**Office européen des brevets**

(19)

(11) Veröffentlichungsnummer : **0 072 417**
**B1**

## (12) EUROPÄISCHE PATENTSCHRIFT

(45) Veröffentlichungstag der Patentschrift :
**11.11.87**

(21) Anmeldenummer : **82105803.9**

(22) Anmeldetag : **30.06.82**

(51) Int. Cl.⁴ : **H 05 C  1/00**, H 05 K  5/06//
**A01K3/00**

(54) Spritzwassergeschütztes elektrisches Gerät, vorzugsweise Elektrozaungerät.

(30) Priorität : **18.08.81 DE 3132524**

(43) Veröffentlichungstag der Anmeldung :
**23.02.83 Patentblatt 83/08**

(45) Bekanntmachung des Hinweises auf die Patenterteilung : **11.11.87 Patentblatt 87/46**

(84) Benannte Vertragsstaaten :
**AT BE CH FR GB IT LI NL SE**

(56) Entgegenhaltungen :
**FR-A- 1 215 051**
**FR-A- 1 301 982**
**FR-A- 1 504 634**
**GB-A- 1 201 282**
**US-A- 2 602 844**
**US-A- 4 227 037**

(73) Patentinhaber : **Horizont Gerätewerk GmbH**
**Homberger Weg 4-6**
**D-3540 Korbach 1 (DE)**

(72) Erfinder : **Seiler, Konrad**
**Lelbach 82**
**D-3540 Korbach (DE)**
Erfinder : **Schmidt, Heinrich**
**Heerstrasse 1**
**D-3540 Korbach (DE)**
Erfinder : **Weinreich, Wilhelm, Dipl.-Ing.**
**Am Taubenrain 9**
**D-3540 Korbach (DE)**

(74) Vertreter : **Seids, Heinrich, Dipl.-Phys.**
**Bierstadter Höhe 15 Postfach 5105**
**D-6200 Wiesbaden (DE)**

## Beschreibung

Die Erfindung bezieht sich auf im Freien aufstellbare und dazu gegen das Eindringen von Spritzwasser geschützte elektrische Geräte, vorzugsweise Elektrozaungeräte, deren Gehäuse für gemeinsame Unterbringung einer Stromquelle, beispielsweise Trockenbatterie, und einer elektrischen Schaltungsanordnung, ein behälterartiges Gehäuseunterteil zur Aufnahme der Stromquelle und ein im wesentlichen deckelartiges Gehäuseoberteil zur Aufnahme der elektrischen Schaltungsteile aufweist, wobei sich das Gehäuseunterteil in einem streifenförmigen Bereich seines Öffnungsrandes ringsum mit einem am Gehäuseoberteil vorgesehenen flanschartigen Umfangswandteil überlappt und an der Außenseite des Gehäuseunterteiles und des Gehäuseoberteiles Verschlußelemente angebracht sind.

Es sind Elektrozaungeräte in den verschiedensten Ausführungen ihres Gehäuses auf dem Markt, die in der Regel so aufgebaut sind, daß in einem Gehäuseoberteil die elektrische Schaltungsanordnung, also der Impulsgenerator, und in einem Gehäuseunterteil eine Stromquelle, meist eine Trockenbatterie untergebracht sind. Der elektrische Impulsgenerator erzeugt Hochspannungsimpulse zur Einspeisung in den Elektrozaun und wird gespeist aus der Stromquelle (z. B. 9V), die in der Lage ist, das Gerät über einige Monate durchgehend zu betreiben. Es muß bei solchen Geräten für den Benutzer einfach und leicht möglich sein, die Batterie zu wechseln, möglichst ohne Benutzung von Werkzeug.

Bei einem aus GB-A-1 201 282 bekannten Elektrozaungerät dieser Art, sind sowohl das Gehäuseoberteil als auch das Gehäuseunterteil an ihrem Öffnungsrand mit einem sich nach außen erstreckenden Flansch versehen. Diese Flansche sind aufeinanderzusetzen und mittels daran angebrachter Verschlußelemente in Art von Schraubenverschlüssen aneinander zu befestigen. Ein gewisser Spritzwasserschutz dieser Flanschverbindung wird dadurch gebildet, daß der Flansch am Öffnungsrand des Gehäuseoberteiles einen zusätzlichen, ringsum erstreckenden streifenförmigen Wandteil trägt, der den Flansch des Gehäuseunterteiles außen axial übergreift. Dieses bekannte Gerät hat jedoch den Mangel, daß zum Auswechseln der Stromquelle im Betrieb des Gerätes fest angezogene Schraubverbindungen gelöst werden müssen, bevor das Gehäuseoberteil abgenommen und die Batterie ausgewechselt werden kann. Nach dem Auswechseln der Batterie und Aufsetzen des Gehäuseoberteiles müssen wiederum die Schraubverbindungen festgezogen werden. Diese Arbeitsweise ist umständlich und im allgemeinen nicht ohne Werkzeug ausführbar. Im übrigen ist bei dem aus GB-A-1 201 282 bekannten Elektrozaungerät ein praktisch luftdichter Verschluß für den Innenraum des Gehäuseunterteils gebildet. Dies macht die Benutzung der für solche Geräte bevorzugten Trockenbatterien unmöglich, die Luftsauerstoff für ihren Betrieb benötigen.

Bei anderen bekannten Geräten solcher Art sind Scharnierverbindungen zwischen dem Gehäuseunterteil und dem Gehäuseoberteil vorgesehen. Bei allen bekannten Gerätegehäusen der oben angesprochenen Art, sei es mit Schraubverbindung oder Scharnierverbindung zwischen dem Geräteoberteil und dem Geräteunterteil, ist die Trennung der beiden Gehäuseteile nur auf relativ umständliche Art vorzunehmen, und es besteht die Gefahr, daß zum Trennen der Gehäuseteile herauszunehmende Lose Verbindungselemente leicht verloren werden. Da solche Geräte im Freien aufgestellt werden, kommt es dann häufig, insbesondere bei Verlust von Verbindungsteilen, nur zu provisorischem Verbinden der Gehäuseteile mit der Gefahr des gänzlichen Ausfalls des Gerätes. Dem Benutzer von Elektrozaungeräten obliegt aber hohe Sorgfaltspflicht, weil bei Ausbrechen von Viehherden aufgrund defekter Elektrozaunanlagen folgeschwere Verkehrsunfälle passieren oder sonstige erhebliche Schäden verursacht werden können.

Es ist daher Aufgabe der Erfindung, im Freien oder in sonstiger abträglicher Umgebung aufzustellende Geräte, insbesondere Elektrozaungeräte der oben angegebenen Art dahingehend wesentlich zu verbessern, daß die sachdienliche Handhabung des jeweiligen Gerätes vereinfacht und dabei extrem servicefreundlicher Aufbau ermöglicht wird, wobei dem Gerätebenutzer ein schneller Austausch sowohl einer verbrauchten Stromquelle als auch eines defekten Geräteteiles an Ort und Stelle ermöglicht sein soll. Das Gerätegehäuse soll frei von korrosionsanfälligen Teilen sein und dem Gerät optimalen Schutz gegen nachteilige äußere Einflüsse, beispielsweise Witterungsschutz bieten und die Geräteteile spritzwassergeschützt halten, wobei zumindest für Teile des Geräteinneren Austausch mit der atmosphärischen Luft möglich sein soll.

Diese Aufgabe wird erfindungsgemäß dadurch gelöst, daß die Verschlußelemente als sich am Gehäuseunterteil parallel zu dessen Öffnungsrand erstreckende untere Verschlußleisten und am Gehäuseoberteil sich parallel zu dessen unteren Rand erstreckende obere Verschlußleisten, die sich bei zusammengesetztem Gehäuse auf die unteren Verschlußleisten setzen, sowie jeweils über ein aufeinandergesetztes Paar von unteren und oberen Verschlußleisten steckbaren, mit Abziehsicherung ausgestattete Schließklammern ausgebildet sind, und daß der flanschartige Umfangswandteil des Gehäuseoberteiles als spritzwassergeschützte Abdichtung in den Öffnungsrand des Gehäuseunterteils greift und in das Innere des Gehäuseunterteils führende, labyrinthartig ausgebildete Lufteinlässe aufweist.

Das sich gegenseitig überlappende Ineinandergreifen von Gehäuseunterteil und Gehäuseoberteil bewirkt in Verbindung mit dem durch die Schiebeverschlußelemente und die Schließklammer bewirkten festen axialen Zusammenziehen der beiden Gehäuseteile einerseits eine spritzwassersichere Abdichtung für den Innenraum des Gehäuseunterteils zusammen mit sicherer, mechanisch fester Verbindung der beiden Gehäuseteile. Andererseits wird die Möglichkeit für den wirksamen Zutritt von Luftsauerstoff zum Inneren des Gehäuseunterteils geschaffen, wie es insbesondere für den Betrieb von Trockenbatterien erforderlich ist. Der durch die Schiebeverschlußelemente mit Schließklammer in Verbindung mit den sich überlappenden Randteilen von Gehäuseunterteil und Gehäuseoberteil erzielten Verschluß ist ohne eine Schraube oder ein sonstiges Verschlußmittel betätigbar und deshalb leicht zu öffnen und zu schließen, wobei die sich überlappenden, ineinandergreifenden Randteile von Gehäuseunterteil und Gehäuseoberteil nicht nur ein gegenseitiges seitliches Verschieben der Gehäuseteile verhindern, sondern auch beim Zusammensetzen und Auseinandernehmen der Gehäuseteile eine günstige Führung bieten. Die mit den Schiebeverschlußelementen und der Schließklammer erreichte, axial wirkende Keilverbindung ist sicherer und stabiler als herkömmliche Scharnierverbindungen. Die Kraftverteilung beim Tragen des Gerätes ist optimal. Die Ausbildung der Durchführungen für bewegte Teile, beispielsweise Schalter sowie Regel- und Prüfeinrichtungen des Gerätes ermöglicht nicht allein die Anordnung dieser Teile an für die Bedienung des Gerätes günstigster, bequemster Stelle, sondern auch die Anbringung solcher Schalter bzw. Regel- oder Prüfeinrichtungen direkt an Schaltungsmodulen.

Bevorzugt kann das Gehäuseoberteil in Art eines Stülpdeckels mit Umfangswand und unterem Öffnungsrand ausgebildet und der sich mit dem Öffnungsrandbereich des Gehäuseunterteiles überlappende Umfangswandteil die Umfangswand eines Zwischenbodens sein, wobei die Umfangswand des Zwischenbodens in den Öffnungsquerschnitt des Gehäuseunterteiles und den Öffnungsquerschnitt des Gehäuseoberteiles passend ausgebildet ist und Einrichtungen zum Verrasten im Oberteil in solcher Lage aufweist, in welcher die Umfangswand des Zwischenbodens gegenüber dem Umfangsrand des Gehäuseoberteiles axial vorsteht. Auf diese Weise wird das Gehäuseoberteil in besonders günstiger Weise zu einem praktisch ringsum geschlossenen, auf das Gehäuseunterteil aufsetzbaren Teilgehäuse, das die elektrischen Schaltungsteile aufnimmt und gegenüber dem die Stromquelle aufnehmenden Innenraum des Gehäuseunterteiles abgeschlossen ist. Zugleich bildet der Zwischenboden ein stabilisierendes Element im Inneren des gesamten Gehäuses, insbesondere im Inneren des Gehäuseoberteiles. Die von oben her in das Gehäuseunterteil ragende Umfangswand des Zwischenbodens legt sich um den oberen Rand der im Gehäuseunterteil eingesetzten Batterie, so daß eine spritzwassergeschützte Lagerung der Batterie gewährleistet ist, auch dann, wenn das Gehäuseunterteil zum einfachen, leichten Einsetzen und Herausnehmen der Batterie entsprechend weit ausgebildet wird.

Eine weitere Verbesserung läßt sich erzielen, wenn die Schiebeverschlußelemente als seitlich an den Gehäuseteilen vorstehende Keilverschlußleisten ausgebildet sind. Durch diese Ausbildung kann mit dem Schiebeverschluß bei besonders leichter Betätigungsweise ein festes Zusammenziehen der beiden Gehäuseteile leicht vorgenommen werden. Das Gehäuseoberteil und das Gehäuseunterteil können hierzu Keilverschlußleisten jeweils als Hälften eines oder mehrerer Keile tragen, die bei seitenrichtigem Zusammensetzen beider Gehäuseteile jeweils einen vollständigen Keil bilden, wobei über diesen Keil formschlüssig eine als Keilhülse ausgebildete Schließklammer gezogen wird. Hierdurch wird erreicht, daß die Schließklammer nur dann formschlüssig über den aus zwei Keilverschlußleisten gebildeten Keil greift, wenn die beiden Gehäuseteile seitenrichtig zusammengesetzt sind. Es wird dadurch eine einfache Sicherung gegen falsches Zusammensetzen der Gehäuseteile geboten.

Die Keilverschlußleisten können bevorzugt in die Wand des Gehäuseoberteiles und die Wand des Gehäuseunterteiles eingeformt sein, während in die Umfangswand des Zwischenbodens in die durch diese Keilverschlußleisten gebildeten rückwärtigen Wandausformungen passende Vorsprünge geformt sind. Diese Vorsprünge der Umfangswand am Zwischenboden bilden auch im Bereich der Keilverschlußleisten genau passende abdichtende Verbindungselemente zwischen den Wänden der Gehäuseteile und der Umfangswand des Zwischenbodens. Außerdem passen aufgrund der Keilform diese Vorsprünge an der Umfangswand des Zwischenbodens nur bei seitenrichtigem Zusammensetzen der Gehäuseteile in die entsprechenden Wandausformungen.

Eine weitere vorteilhafte Weiterbildung der Erfindung besteht darin, daß die Umfangswand des Zwischenbodens in vorgegebener Höhe, beispielsweise im wesentlichen mittlerer Höhe, einen nach außen vorstehenden Flansch aufweist, der sich bündig zwischen die Stirnflächen der Wände des Gehäuseunterteils und des Gehäuseoberteils legt. Durch diesen Flansch wird einerseits die Lage des Zwischenbodens, insbesondere bezüglich des Gehäuseoberteiles, genau definiert. Es wird aber auch ein gegenseitiges Verkeilen der fest zusammengezogenen Gehäuseteile verhindert. Schließlich bietet der Flansch eine vorteilhafte zusätzliche Abdichtung des geschlossenen Gehäuses.

Die Abziehsicherung der Schließklammer kann ein an dieser angebrachter, bei vollständigem Aufziehen auf die Schiebeverschlußelemente hinter entsprechend vorstehende Teile am Gehäuse greifender Schnapphaken sein. Ein solcher Schnapphaken läßt sich einfach und sicher betätigen und in einfacher Weise an der Schließklammer anbringen bzw. ausbilden.

In einer besonders vorteilhaften Ausführungsform der Erfindung kann an zwei sich gegenüberliegenden Wandbereichen des Gehäuses je ein Paar von Keilverschlußelementen angeordnet sein, und es können zwei Schließklammern über einen Bügel miteinander verbunden sein, der als sich mit Abstand über das Geräteoberteil erstreckender Tragegriff ausgebildet ist. Hierdurch wird die Kraftverteilung beim Tragen des Gerätes besonders günstig. Die Batterie hat in der Regel ein Gewicht von ca. 3 kg und ist damit der weitaus schwerste Teil des ganzen Gerätes. Bei den meisten herkömmlichen Geräten ist der Tragegriff auf dem Oberteil angebracht oder befestigt, wodurch der Kraftfluß durch die Wandung des Gehäuseoberteiles und die Scharnierverbindung zum Gehäuseunterteil verläuft. Durch die Ausbildung des Tragegriffes an einem Paar von Schließklammern ist das Gehäuseoberteil völlig aus dem Kraftweg genommen und zusätzlich gegen Stoß und Fallbeanspruchung geschützt.

Die Verrastung des Zwischenbodens im Gehäuseoberteil kann in vorteilhafter Weiterbildung der Erfindung dadurch erfolgen, daß am oberen Rand mindestens zweier sich gegenüberliegender Bereiche der Zwischenboden-Umfangswand nach außen vorspringende horizontale Rippen oder Nasen und in den entsprechenden Wandbereichen des Gehäuseoberteiles entsprechende Aufnahmeöffnungen ausgebildet sind. Diese Rippen oder Nasen greifen in die entsprechenden Aufnahmen in der Wand des Gehäuseoberteiles und bilden somit eine sichere Rastverbindung, durch die gewährleistet ist, daß der Zwischenboden beim Öffnen des Gerätes stets mit dem Gehäuseoberteil verbunden bleibt, der die elektrischen Schaltungsteile enthaltende Innenraum des Gehäuseoberteiles nur durch Lösen dieser sicheren Rastverbindung, d. h. gewollt geöffnet werden kann. Für den Innenraum des Gehäuseunterteiles ist eine gegen Eindringen von Feuchtigkeit und Regen sichere Belüftung vorgesehen. Hierzu können an der Umfangswand des Zwischenbodens, beispielsweise im Bereich unterhalb der horizontalen Rippen bzw. Nasen, in den Innenraum des Gehäuseunterteiles führende, vertikale Nuten ausgebildet sein.

Sofern die Umfangswand des Zwischenbodens einen nach außen vorstehenden Flansch aufweisen, wird man diesen im Bereich der vertikalen Nuten unterbrechen.

In vorteilhafter Weiterbildung und Ergänzung der Erfindung kann der als Stabilisierungselement wirksame Zwischenboden mit Pufferelementen ausgestattet sein. So kann der Zwischenboden an seiner Unterseite Pufferelemente tragen, die sich auf der Stromquelle abstützen. Der Zwischenboden kann auch auf der Oberseite Pufferelemente tragen, die sich gegen die im Gehäuseoberteil untergebrachten elektrischen Schaltungsteile setzen. Dabei kann vorgesehen sein, daß die elektrische Schaltungsanordnung in Form mehrerer Schaltungsmodule mit Steckverbindungen aufgebracht ist und die an der Oberseite des Zwischenbodens angebrachten Pufferelemente als Halteeinrichtung zum Zusammenhalten der zusammengesteckten Schaltungsmodule ausgebildet sind.

Bei dem erfindungsgemäßen Gerät enthält die elektrische Schaltungsanordnung bevorzugt mindestens ein in das Gehäuseoberteil eingesetztes Schaltungsmodul, an dem mindestens ein von außen betätigbarer Schalter und bzw. oder eine von außen betätigbare Regel- oder Prüfeinrichtung unmittelbar angebracht und mit seinem bzw. ihrem das Bedienungselement tragenden Betätigungsteil durch eine Labyrinthdichtung spritzwassergeschützt auf die Außenseite des Gehäuseoberteiles ragt. Die direkte Anbringung solcher Schalter bzw. Regel- oder Prüfeinrichtungen auf dem einen oder anderen Schaltungsmodul verbilligt nicht allein die Herstellung der elektrischen Schaltungsanordnung des Gerätes, sondern bietet auch die leichte, schnelle Austauschbarkeit solcher durch die Betätigung oftmals am schnellsten verschleißenden Schaltungsteile zusammen mit der entsprechenden Modulplatte. Zugleich bietet diese bevorzugte Ausführungsform die Möglichkeit, die Bedienungselemente solcher Schalter und Regel- oder Prüfeinrichtungen an besonders günstiger Stelle am Gehäuseoberteil anzuordnen.

Dabei kann das Bedienungselement ein mit Stirnwand und Umfangswand und mittlerem, rückwärtigem Verbindungsschaft ausgebildeter Drück- oder Drehknopf sein, der mit seinem Umfang passend in einer am Gehäuseoberteil, vorzugsweise dessen Umfangswand, als Vertiefung ausgebildeten Aufnahme bewegbar angebracht ist. Auf diese Weise bildet das Bedienungselement einen praktisch glatten Abschluß mit der Wandfläche des Gehäuseoberteiles. Es verbleibt dann lediglich ein schmaler, für die Bewegbarkeit des Drück- oder Drehknopfes notwendiger Schlitz, durch den Regenwasser nicht und Spritzwasser nur in verschwindend kleiner Menge eindringen kann. Diese geringe Spritzwassermenge wird aber mit Sicherheit von der Labyrinthdichtung zurückgehalten und kann nicht in das Innere des Gehäuseoberteiles eindringen. Die Labyrinthdichtung kann dabei durch eine in der Bodenwand der Aufnahme vorgesehene und sich mit der Umfangswand des Drück- oder Drehknopfes überlappende Labyrinthbuchse gebildet sein, die den Betätigungsteil des Schalters bzw. des Regel- oder Prüfelementes und den Verbindungsschaft des Drück- oder Drehknopfes aufnimmt. Als weitere Verbesserung dieser Abdichtung kann die als Vertiefung in der Wand, vorzugsweise Umfangswand, des Gehäuseoberteiles ausgebildete Aufnahme einen auf die Gehäuse-Außenseite führenden Wasserablauf aufweisen. Hierdurch werden die zwischen dem Umfang des Drück- oder Drehknopfes und dem Rand der Aufnahme eindringenden geringfügigen Wassermengen sicher aus der Aufnahme wieder abgeleitet.

Eine zusätzliche Sicherung der elektrischen Schaltungsanordnung gegen Feuchtigkeit kann vorzugsweise dadurch erreicht werden, daß die im Gehäuseoberteil untergebrachten Schaltungsteile, insbesondere Schaltungsmodule einen Feuchtigkeitsschutz aufweisen. Da die Labyrinthdichtung das Eindringen von Nebel oder Feuchtluft in das Innere des Gehäuseoberteiles zuläßt, könnte es bei Temperaturschwankungen vorkommen, daß Schaltungsteile mit Feuchtigkeit beschlagen. Ein solcher Feuchtigkeitsschutz beispielsweise eine Paraffinschicht o. dgl. macht die Schaltungsteile gegen solches Beschlagen mit Feuchtigkeit unempfindlich.

Im Rahmen von Weiterbildungen der Erfindung bieten sich auch besonders günstige Anordnungsmöglichkeiten für die elektrischen Anschlußklemmen. So können bevorzugt die elektrischen Anschlußklemmen in am Gehäuseoberteil ausgebildeten Mulden angeordnet sein.

In bevorzugter Ausführungsform der Erfindung sind die Aufnahme für die Bedienungselemente für elektrische Schalter und bzw. oder Regel- und Prüfeinrichtungen an der einen Stirnseite des Gehäuseoberteiles unmittelbar unterhalb dessen Deckenwand angeordnet und die die Anschlußklemmen aufnehmenden Mulden in den oberen Eckbereichen der gegenüberliegenden Stirnseite des Gehäuseoberteiles gebildet. Durch diese Anbringungsweise der Bedienungselemente und der Anschlußklemmen werden das Anschließen und das Bedienen des Gerätes besonders übersichtlich und sicher sowie besonders bequem für den Benutzer.

Eine weitere Verbesserung für die spritzwassergeschützte Lagerung der Stromquelle im Gerät und die leichte Austauschbarkeit der Stromquelle ergibt sich in bevorzugter Ausführungsform der Erfindung dadurch, daß das Geräteunterteil — ggf. mittels zusätzlicher Einsätze — dazu ausgebildet ist, daß eine eingesetzte Stromquelle stets in den innerhalb des Umfangswandteiles am Gehäuseoberteil gebildeten Hohlraum ragt.

Ein Ausführungsbeispiel der Erfindung wird im folgenden anhand der Zeichnung näher erläutert. Es zeigen :

Fig. 1 ein erfindungsgemäßes Elektrozaungerät in geschlossenem Zustand in Seitenansicht ;

Fig. 2 das geschlossene Gerät gemäß Figur 1 in Vorderansicht nach 2-2 der Figur 1 ;

Fig. 3 das Gerät gemäß Figur 1 bei geöffnetem Gehäuse in Seitenansicht ;

Fig. 4 das Gerät gemäß Figur 3 bei geöffnetem Gehäuse in Vorderansicht nach 4-4 der Figur 3 ;

Fig. 5 das Gerät gemäß Figur 1 beim ersten Schritt zum Öffnen seines Gehäuses ;

Fig. 6 das Gerät nach Figur 1 beim letzten Schritt zum Schließen des Gehäuses ;

Fig. 7 den Zwischenboden eines Gerätegehäuses nach Figur 1 bis 6 in Draufsicht gegenüber Figur 1 bis 6 vergrößert ;

Fig. 8 den Zwischenboden gemäß Figur 7 in Seitenansicht ;

Fig. 9 einen Schnitt nach 9-9 der Figur 7 ;

Fig. 10 einen Schnitt nach 10-10 der Figur 7 ;

Fig. 11 einen Schnitt nach 11-11 der Figur 7 ;

Fig. 12 den Ausschnitt 12 der Figur 11 nochmals vergrößert und bei geschlossenem Gerätegehäuse und angesetzter Schließklamme ;

Fig. 13 eine vergrößerte, teilweise aufgebrochene Darstellung des Bereiches 13 der Figur 6 in abgewandelter Ausführung ;

Fig. 14 einen nochmals vergrößerten Schnitt 14-14 der Figur 13 ;

Fig. 15 das deckelartige Gehäuseoberteil mit eingesetztem Zwischenboden, das Gehäuseoberteil im Schnitt 15-15 der Figur 18 und der Zwischenboden in Seitenansicht ;

Fig. 16 den Ausschnitt 16 der Figur 15 vergrößert ;

Fig. 17 einen Schnitt nach 17-17 der Figur 16 ;

Fig. 18 das Gehäuseoberteil ohne Zwischenboden, jedoch mit eingesetzten elektrischen Schaltungsteilen in Unteransicht nach 18-18 der Figur 15 ;

Fig. 19 einen Schnitt 19-19 der Figur 18 und

Fig. 20 einen Schnitt 20-20 der Figur 18.

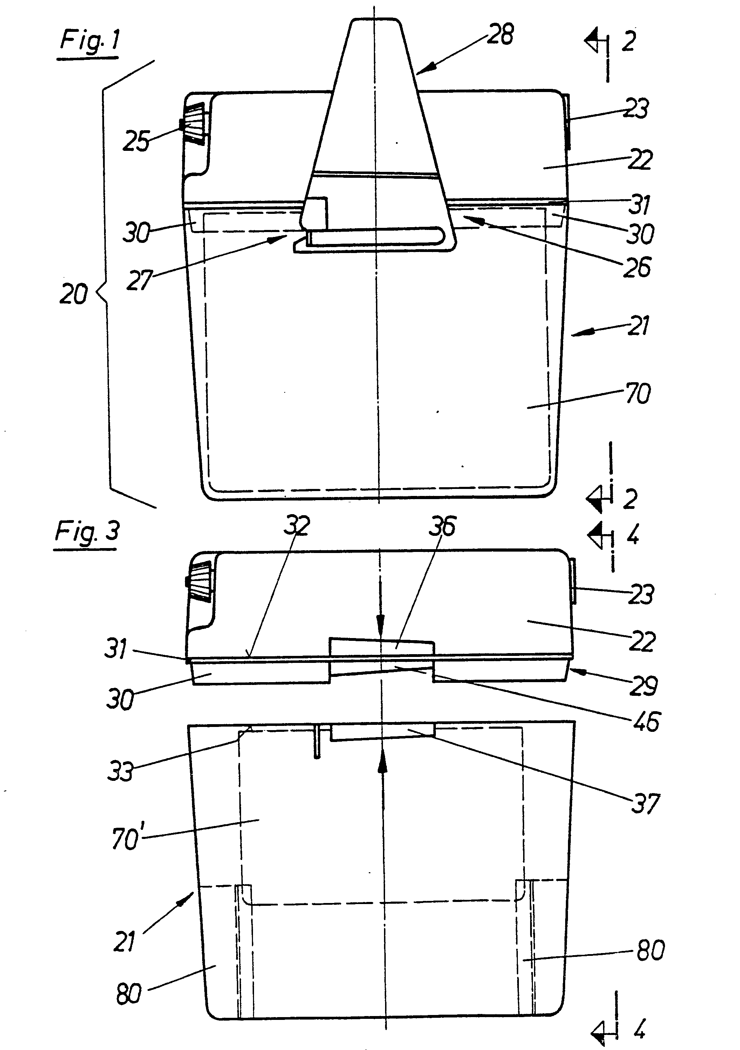

Im dargestellten Beispiel hat das Gerätegehäuse 20 einen behälterartigen Gehäuseunterteil 21, in dessen Innenraum die für den Betrieb des Elektrozaungerätes benötigte Stromquelle, insbesondere eine Trockenbatterie, unterzubringen ist. Auf das Geräteunterteil 21 ist ein deckelartiges Geräteoberteil 22 aufgesetzt, das — wie die Zeichnung zeigt — ausreichende Höhe aufweist, um in seinem Innenraum die elektrischen Schaltungsteile des Elektrozaungerätes unterbringen zu können. Die Figuren 1 bis 6 zeigen dementsprechend die Betätigungsknöpfe 23 (Ein-Ausschalter und Batterieprüfung) sowie Kontrollampen 24, 68 und Anschlußklemmen 25 für den Elektrozaun. Das Gehäuseunterteil 21 und das Gehäuseoberteil 22 werden durch einen Schiebeverschluß 26 zusammengehalten, der mit einer Abziehsicherung 27 ausgestattet und zugleich mit dem Tragegriff 28 des Gerätegehäuses 20 kombiniert ist.

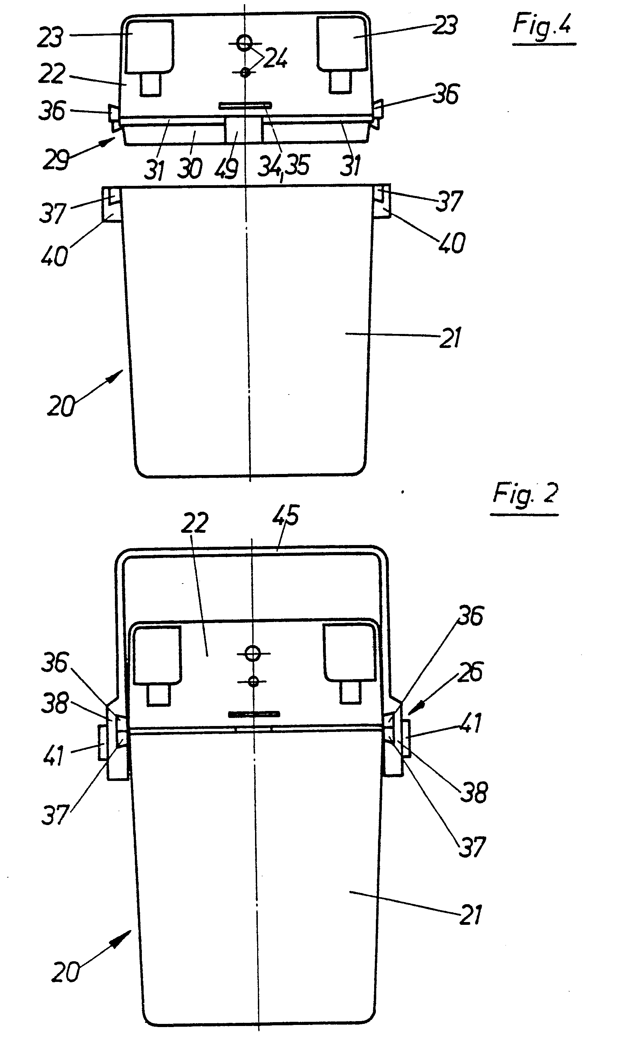

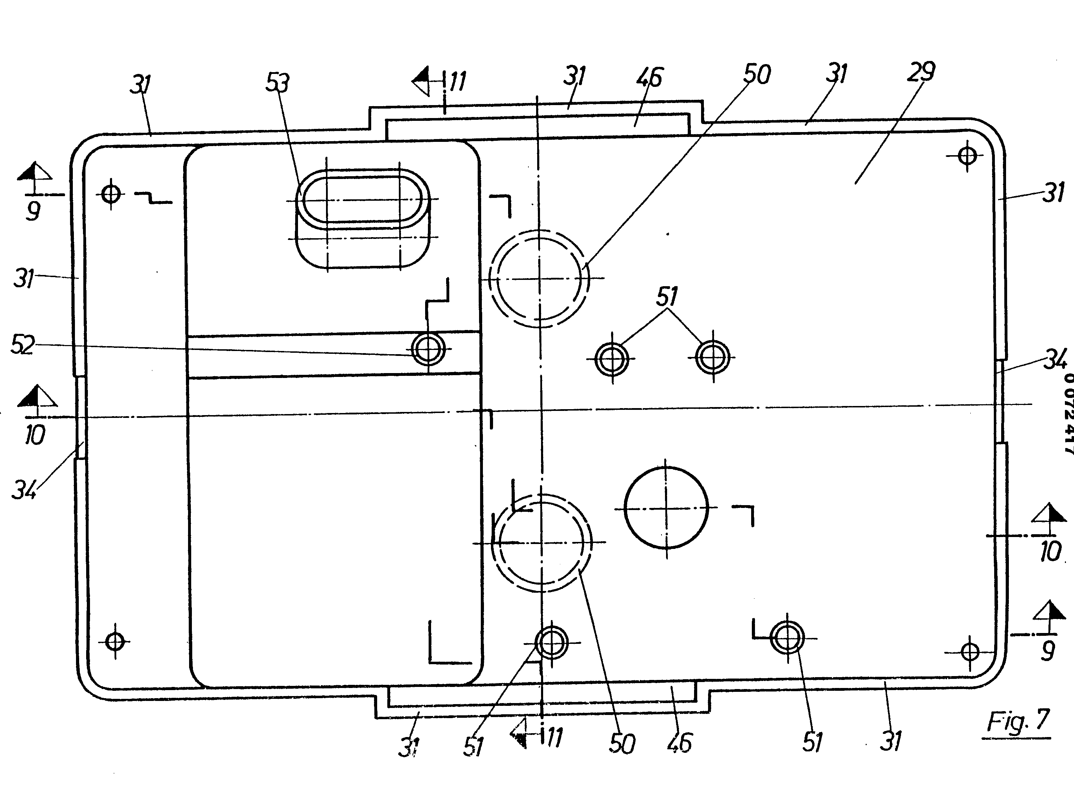

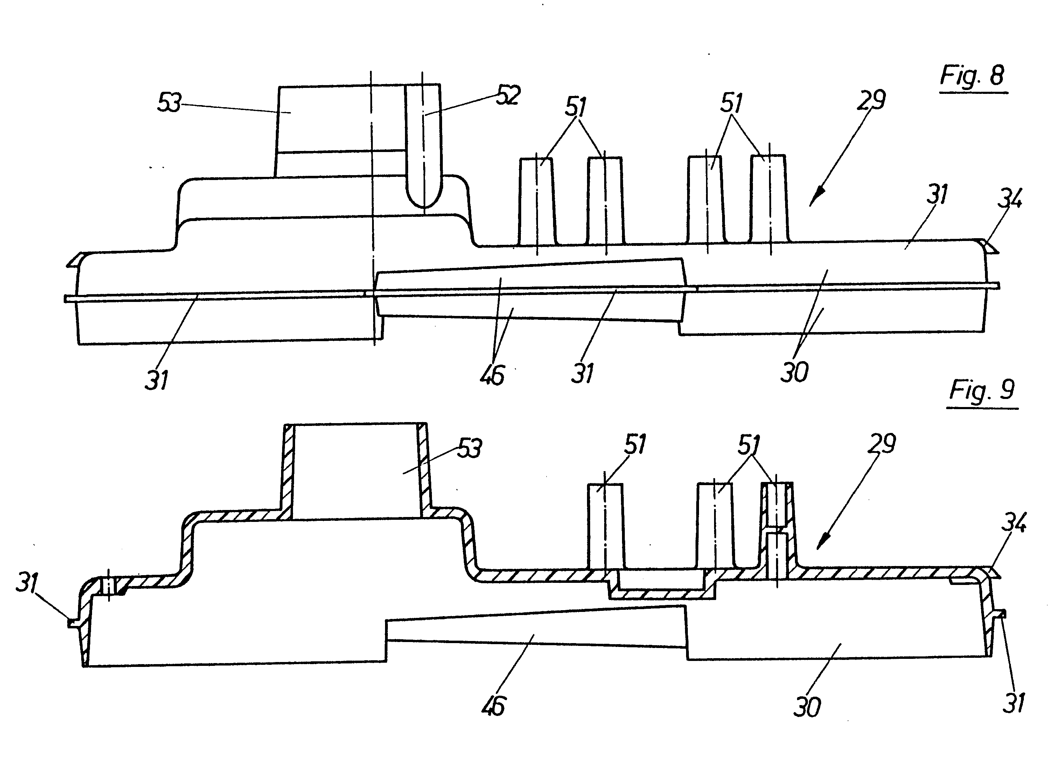

Das Gerätegehäuse 20 ist ferner mit einem Zwischenboden 29 (vergl. Figuren 7 bis 12) ausgestattet, der mit einem an seiner Umfangswand 30 ausgebildeten, nach außen vorstehenden Flansch 31 zwischen die öffnungsseitigen Stirnflächen 32 und 33 an den Umfangswänden des Gehäuseunterteiles 21 und des Gehäuseoberteiles 22 greift und mit der Außenfläche des Gerätegehäuses 20 bündig abschließt, so daß sich ein im wesentlichen glatter Übergang von der Außenfläche des Gehäuseoberteiles 22 zur Außenfläche des Gehäuseunterteiles 21 ergibt und dadurch Regenwasser ungehindert abfließt, ohne daß Feuchtigkeit in das Innere des Gerätegehäuses eindringt. Dies wird sichergestellt in Verbindung mit der Umfangswand 30 des Zwischenbodens 29, die in Figur 3 und 4 nur mit ihrem unteren, in den Gehäuseunterteil 21 ragenden Teil zu sehen ist, während die Figuren 8 bis 12 erkennen lassen, daß die Umfangswand 30 des Zwischenbodens 29 einen beispielsweise ebenso breiten Bereich oberhalb des Flansches 31 aufweist und mit diesem oberen Teil in die Öffnung des Gehäuseoberteiles 22 paßt.

Wie aus Figur 3 und 4 ersichtlich, verbleibt der Zwischenboden 29 beim Öffnen des Gerätegehäuses in Gehäuseoberteil 22, weil er an jeder Schmalseite seiner Umfangswand 30 eine Rippe 34 trägt, die in einen entsprechenden horizontalen Schlitz 35 in den Schmalseiten der Umfangswand des Gehäuseoberteiles 22 eingerastet ist (siehe Figur 4). Das Verrasten erfolgt dadurch, daß sowohl das Gehäuseoberteil 22, als auch der Zwischenboden 29 aus Kunststoff geformt sind und dementsprechend elastische Nachgiebigkeit aufweisen. Auch das Gehäuseunterteil kann aus Kunststoff hergestellt sein. Allerdings kommt auch Herstellung aus Leichtmetall o. dgl. für das Gehäuseunterteil 21 in Betracht.

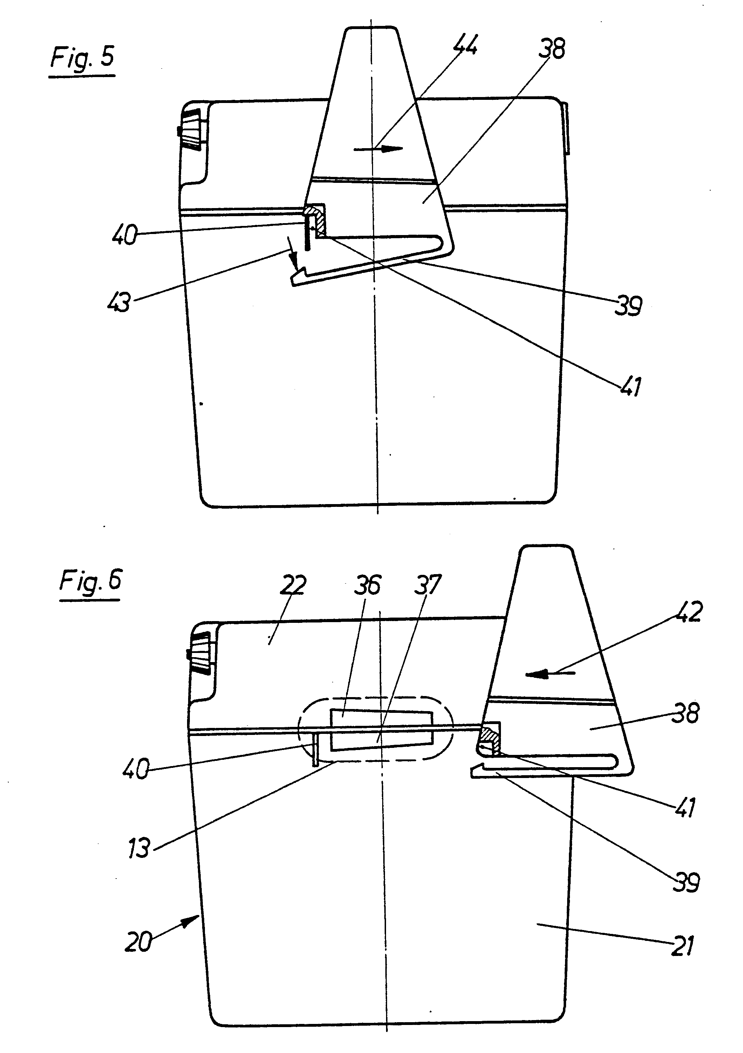

Die an der Außenseite des Gehäuseunterteiles 21 und des Gehäuseoberteiles 22 angebrachten Elemente des Schiebverschlusses 26 sind durch Keilverschlußleisten 36, die an dem unteren Rand der mittleren Seitenwandbereiche des Gehäuseoberteiles 22 angeformt sind und durch Keilverschlußleisten 37 gebildet, die an dem oberen Rand der mittleren Seitenwandbereiche des Gehäuseunterteiles 21 angeformt sind und sich — wie Figur 6 zeigt — bei richtig zusammengesetztem Gehäuseunterteil 21 und Gehäuseoberteil 22 genau gegenüberliegen, um an jeder Seitenwand einen Keil zu bilden, über den jeweils eine Schließklammer 38 aufzuziehen ist.

Wie die Figuren 2 und 4 zeigen, weist der durch die Keilverschlußleisten 36 und 37 gebildete Keil einen im übrigen sich nach außen schwalbenschwanzförmig erweiternden Querschnitt auf, damit ein seitliches Abziehen der Schließklammer 38 unmöglich gemacht wird. Wie die Figuren 3, 6, 8, 11 und 12 zeigen, erstreckt sich der Flansch 31 an der Umfangswand 30 des Zwischenbodens 29 durchgehend durch den Bereich der Keilverschlußleisten 36 und 37, so daß dieser Flanschteil beim Zusammendrücken der Keilverschlußleisten 36 und 37 von der Schließklammer 38 mit gefaßt wird. Jede Schließklammer 38 ist — wie die Figuren 1, 5 und 6 zeigen — an ihrer Unterseite mit einem federnd nach unten biegbaren Schnapphaken 39 versehen, der einstückig an der Schließklammer 38 ausgebildet sein kann. Dieser Schnapphaken 39 bildet zusammen mit einer Widerlager- und Rückhalteplatte 40 (Figuren 5 und 6) die Abziehsicherung 27.

Wie Figur 5 zeigt, ist an dem dem Greifende des Schnapphakens 39 gegenüberliegenden Teil der Schließklammer 38 eine Aufnahmekammer 41 für die Widerlager- und Rückhalteplatte 40 gebildet, die mit ihrer rückwärtigen Wand einen auf die Widerlager- und Rückhalteplatte 40 treffenden Endanschlag für das Aufziehen der Schließklammer 38 im Sinne des Pfeiles 42 bildet. Vor Erreichen dieses Anschlages läuft das Greifende des Schnapphakens 39 über die Unterkante der Widerlager- und Rückhalteplatte und rastet aufgrund seiner eigenen Federwirkung hinter dem unteren Teil der Widerlager- und Rückhalteplatte 40 ein, wodurch das Abziehen der Schließklammer 38 von den Keilverschlußleisten 36 und 37 solange verhindert wird, wie nicht der Schnapphaken 39 durch Abwärtsbiegen entsprechend dem Pfeil 43 in Figur 5 von der Widerlager- und Rückhalteplatte gelöst wird. Erst dann kann die Schließklammer 38 im Sinne des Pfeiles 44 in Figur 5 von den Keilverschlußleisten 36 und 37 abgezogen werden. Durch diese Ausbildung werden für die Funktion des Gerätegehäuses 20 wichtige Forderungen erfüllt:

a) die Schließklammer darf nicht zu weit aufschiebbar sein, da es sonst zum Verklemmen führt und ein leichtgängiges Lösen der Schließklammer verhindert wird.

b) In der Schließstellung muß ein automatisches Arretieren der Schließklammer erfolgen, das auch bei flüchtigem, eiligem Verschließen des Gehäuses mit Sicherheit eintritt und nur durch eine gewollte Tätigkeit gelöst werden kann.

Trotzdem ist in der Praxis das Aufschieben und das Lösen der Schließklammer ein einfacher und schneller Vorgang, den auch der absolute Laie sofort versteht und nachvollziehen kann, im Gegensatz zu vielen bekannten Geräteverschlüssen, bei denen erst Anleitungen zu studieren oder zumindest Überlegungen zu treffen sind.

Eine weitere wesentliche Verbesserung ergibt sich dadurch, daß die Keilverschlußleisten 36 und 37 im mittleren Bereich der beiden gegenüberliegenden Seiten des Gerätegehäuses 20 angeordnet sind, wodurch ein Paar von Schließklammern 38 benötigt wird, und daß diese Schließklammern 38 über einen Bügel 45 miteinander verbunden sind, der zugleich den Tragegriff 28 für das Gerätegehäuse 20 bildet. Dadurch lassen sich die Schließklammern 38 nur gemeinsam abziehen, nachdem ihre Rasthaken 39 gemeinsam von den beiden Widerlager- und Rückhalteplatten 40 gelöst worden sind.

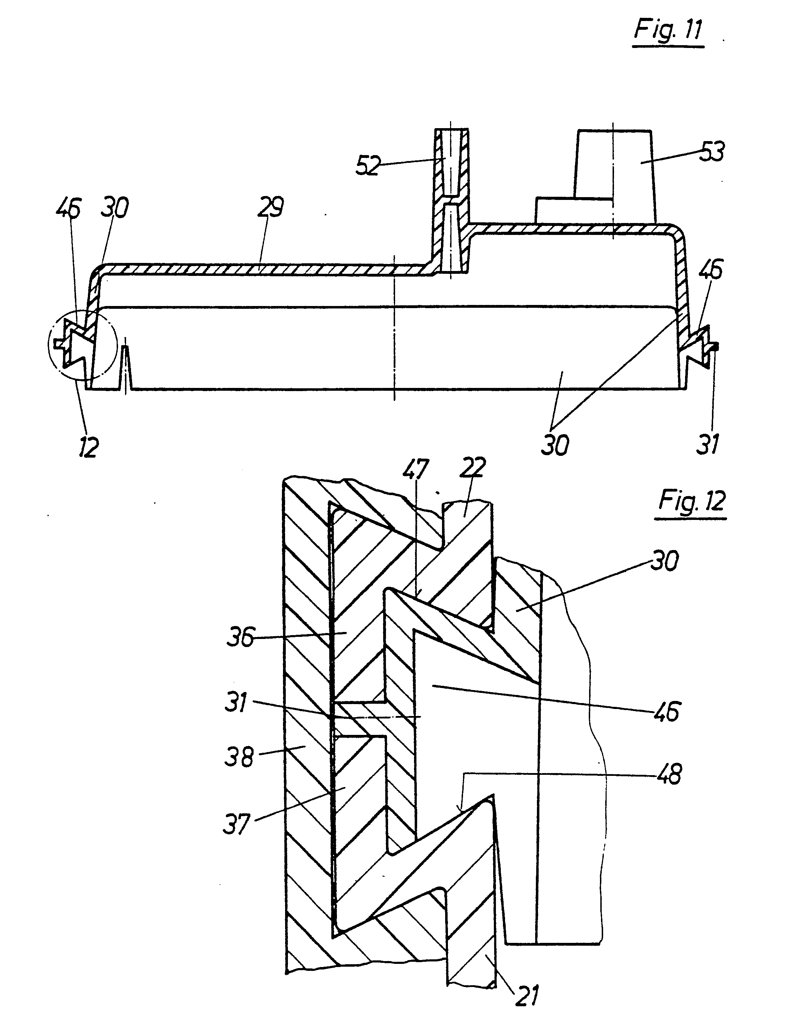

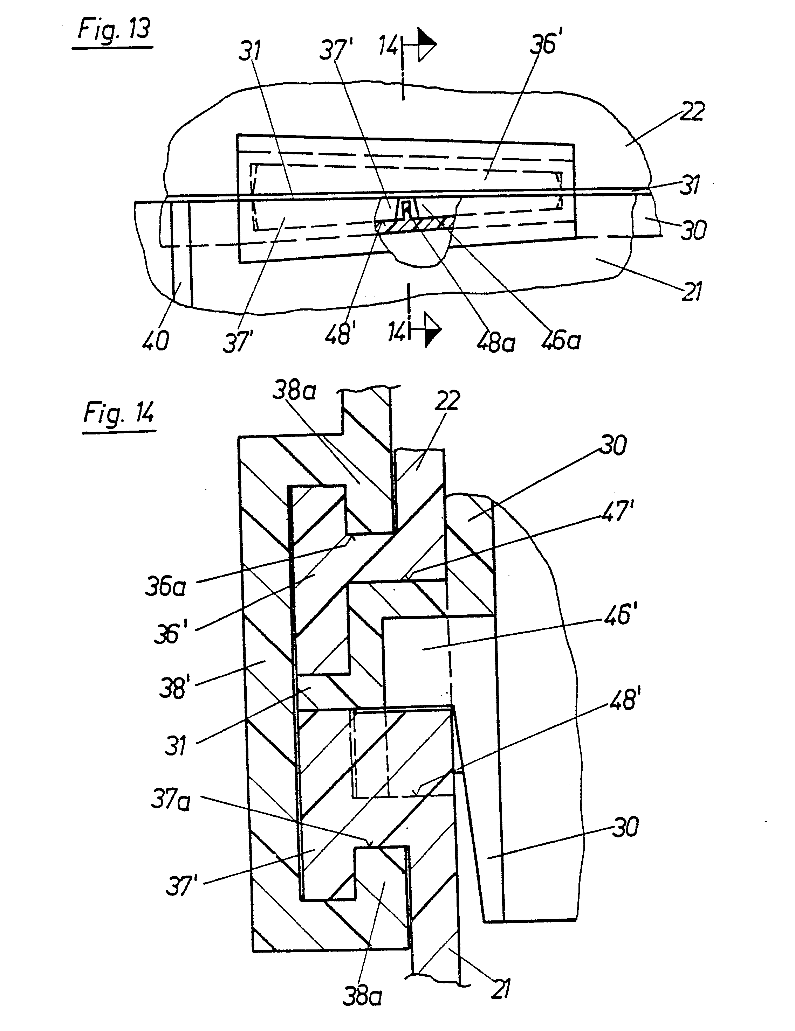

Der Zwischenboden 29 bildet mit an ihm ausgebildeten Einrichtungen einen wirksamen Stabilisator für das Gehäuse 20. Dies gilt in erster Line für den an der Umfangswand 30 ausgebildeten, nach aussen vorstehenden Flansch 31. Wie die Figuren 7 bis 9 und 11 bis 14 zeigen, ist die Umfangswand 30 des Zwischenbodens 29 in den Bereichen der in die Umfangswand des Gehäuseoberteiles 22 eingeformten Keilverschlußleisten 36 bzw. 36' und in den Bereichen der in die Umfangswand des Gehäuseunterteiles 21 eingeformten Keilverschlußleisten 37 bzw. 37' mit einem keilförmigen Vorsprung 46 bzw. 46' ausgebildet, der an seiner Außenwand den durchgehenden Teil des Flansches 31 trägt. Wie die Figuren 12 und 14 zeigen, paßt der Vorsprung 46 bzw. 46' in die durch die Ausbildung der Keilverschlußleisten 36 bzw. 36' und 37 bzw. 37' entstehenden inneren Ausformungen 47 bzw. 47' und 48 bzw. 48' in den entsprechenden Umfangswandbereichen des Gehäuseoberteiles 22 und des Gehäuseunterteiles 21.

In der Ausführung nach den Figuren 11 und 12 sind die Keilverschlußleisten 36 und 37 schwalbenschwanzförmig profiliert und werden dementsprechend mit einer Schwalbenschwanz-Aufnahme in den Schließklammern 38 umgriffen. Entsprechend sind gemäß Figur 12 auch die inneren Ausformungen 47 und 48 und der keilförmige Vorsprung 46 des Zwischenbodens 29 mit Schwalbenschwanz-Profil ausgebildet. Hierdurch erhalten die Umfangswandbereiche des Gehäuseoberteiles 22 und des Gehäuseunterteiles im Bereich der Keilverschlußleisten 36 und 37 einen zusätzlichen seitlichen Halt am Zwischenboden 29 bzw. dessen Umfangswand 30.

In der Ausführung nach den Figuren 13 und 14 ist die Keilverschlußleiste 36' am Gehäuseoberteil 22 an ihrer Oberseite mit einer sich auf die gesamte Länge der Keilverschlußleiste 36' erstreckenden Aufnahmenut 36a ausgebildet. Entsprechend ist die Keilverschlußleiste 37' am Gehäuseunterteil 21 an der Unterseite über ihre gesamte Länge mit einer Aufnahmenut 37a ausgebildet. In diese Aufnahmenuten 36a und 37a greifen an der jeweiligen Schließklammer 38 ausgebildete keilförmige Halteleisten 38a. Die Ausformungen 47' sowie die keilförmigen Vorsprünge 46' haben in diesem Beispiel keine besondere, seitlich verriegelnde Profilierung.

In beiden Ausführungen haben die Ausformungen 47 bzw. 47' und 48 bzw. 48' (bedingt durch die Keilform der Keilverschlußleisten 36 bzw. 36' und 37 bzw. 37') ebenfalls Keilform. Dadurch können die keilförmigen Vorsprünge 46 bzw. 46' in jedem Fall nur in richtiger Orientierung des Zwischenbodens 29 zum Gehäuseoberteil 22 in die Ausformungen 47 bzw. 47' eingesetzt werden. Ebenso ist das Gehäuseoberteil 22 mit dem eingesetzten Zwischenboden 29 nur in richtiger Lage auf das Gehäuseunterteil 21 aufsetzbar, weil nur in dieser Lage die Vorsprünge 46 bzw. 46' in die Ausformungen 48 bzw. 48' am Gehäuseunterteil 21 passen. Will man jedoch eine zusätzliche Sicherung gegen falsches Aufsetzen des Gehäuseoberteiles 22 mit Zwischenboden 29 auf das Gehäuseunterteil 21 schaffen, so kann — wie in den Figuren 13 und 14 gezeigt — in der Ausformung 48' der einen Keilverschlußleiste 37' des Gehäuseunterteiles 21 ein innerer Nocken 48a eingeformt sein, der in eine Ausnehmung 46a nur eines der keilförmigen Vorsprünge 46' vorgesehen ist. Dadurch ist ein Zusammensetzen nur möglich, wenn der mit der Ausnehmung 46a versehene keilförmige Vorsprung 46' in die den inneren Nocken 48a aufweisende Ausformung 48' eingeführt wird. Dieses für seitenrichtiges Aufsetzen des Gehäuseoberteiles 22 auf das Gehäuseunterteil 21 ist unabhängig von der Profilierung der Keilverschlußleisten 36 bzw. 36' und 37 bzw. 37' und könnte ebenso auch im Beispiel der Figuren 11 und 12 vorgesehen sein.

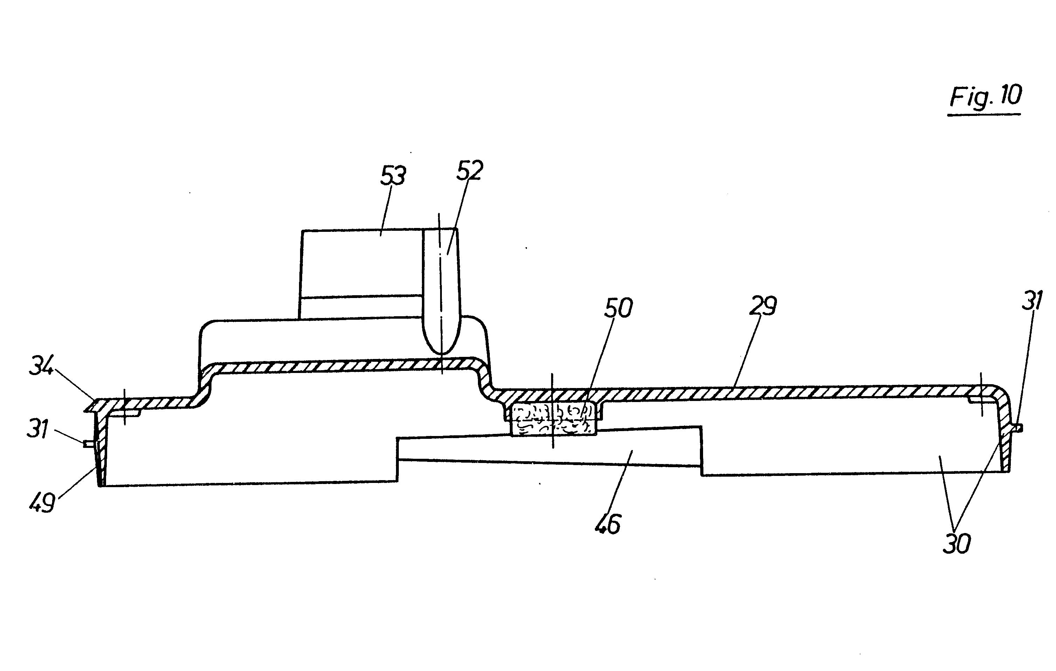

Die dem Gehäuseunterteil 21 zugeordneten Lufteinlässe können als flache, vertikale Nuten 49 im unteren Teil der Umfangswand 30 des Zwischenbodens 29 ausgebildet werden. Man wird im Bereich dieser vertikalen Nuten 49 den Flansch 31 an der Umfangswand 30 unterbrechen, um einen schlitzförmigen Lufteinlaß zwischen den Stirnflächen 32 und 33 an den Umfangswänden des Gehäuseunterteiles 21 und des Gehäuseoberteiles 22 zu bilden. Wie Figur 4 zeigt, wird man bevorzugt diese Lufteinlässe bzw. diese vertikalen Nuten 49 im Bereich unterhalb der Rastrippe 34 an der Umfangswand 30 des Zwischenbodens 29 ausbilden (vergl. auch Figur 10).

Wie Figur 10 zeigt, können an der Unterseite der Zwischenwand 29 nachgiebige Pufferelemente 50, beispielsweise Schaumstoffpuffer, angebracht sein, die sich auf der Stromquelle, beispielsweise einer in das Gehäuseunterteil 21 eingesetzten Trockenbatterie, abstützen, um beim Transport der im Gehäuse 20 aufgenommenen Stromquelle eine sichere abgedämpfte Lagerung zu gewährleisten.

Das Gerätegehäuse 20 kommt mit der mechanisch stabilisierenden Wirkung des Zwischenbodens dem sich zunehmend durchsetzenden Modul-Aufbau elektronischer Geräte entgegen. Wie die Figuren 7 bis 15 zeigen, können an der Oberseite des Zwischenbodens auch die verschiedensten Pufferelemente vorgesehen sein. So weist beispielsweise der Zwischenboden an der Oberseite vier stützenartige Pufferelemente 51 auf, die beispielsweise als Halter für den Impulstransformator eines Elektrozaungerätes dienen können.

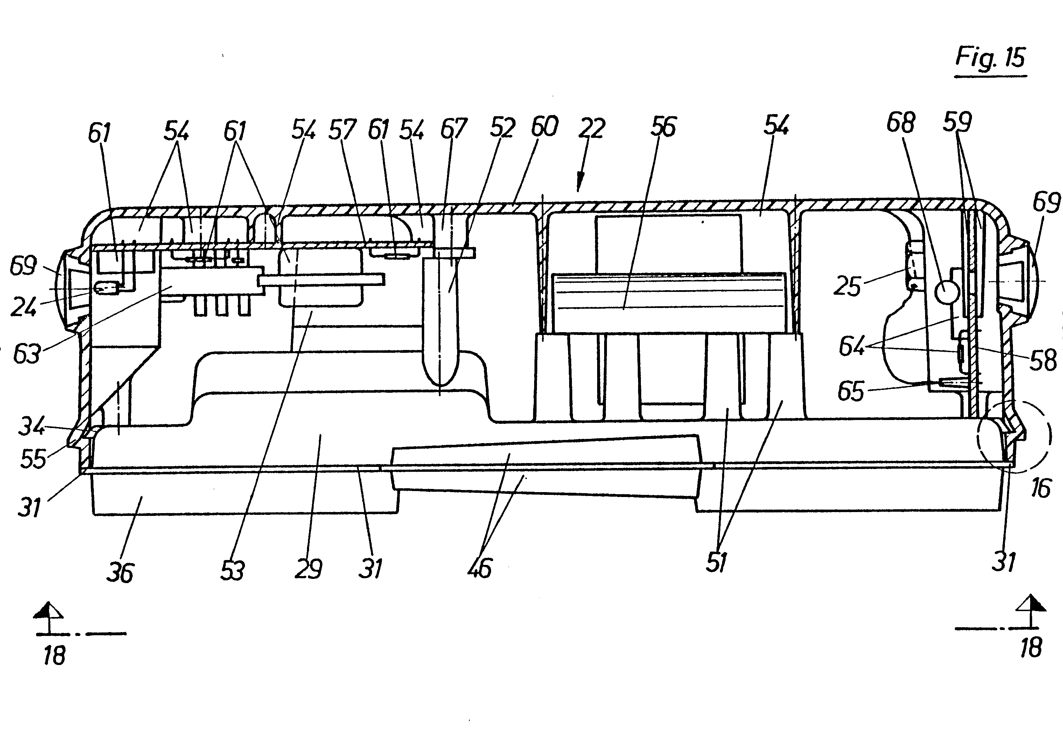

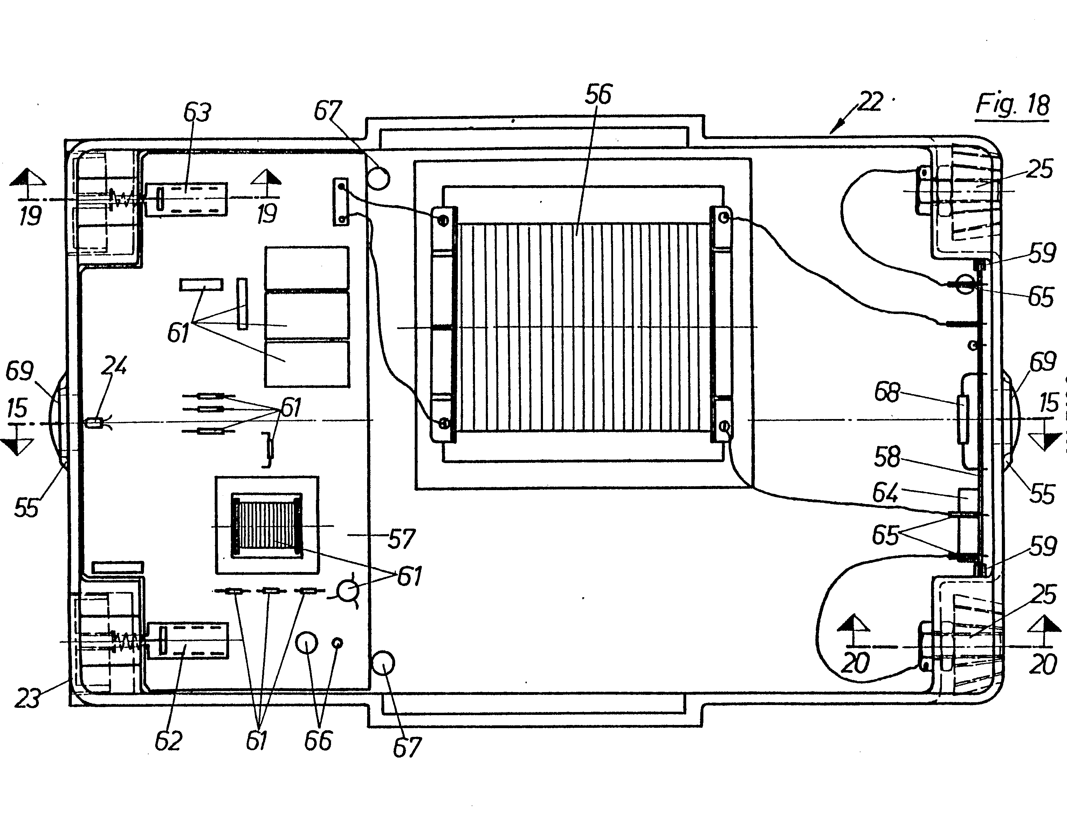

Weitere stützenartige Halter- und Pufferelemente 52 können zur Unterstützung einzelner plattenförmiger Schaltungsmodule dienen. Ferner ist ein kaminartiges Halter- und Pufferelement 53 vorgesehen, das die die Steckkontakte zum Anschließen der Schaltungsanordnung an die Stromquelle tragende Modulplatte unterstützt und den über ein Zuleitungskabel mit der Stromquelle verbundenen Anschlußstecker aufnimmt. Durch diese verschiedenartigen Pufferelemente 51, 52, 53 an der Oberseite des Zwischenbodens werden zusammengesteckte Schaltungsmodule des Elektrozaungerätes in ihrer richtigen Stellung und in zusammengestecktem Zustand zusammengehalten. Wie die Figuren 15 und 18 zeigen, sind im Inneren, insbesondere an der Innenseite der Deckenwand 60 des Gehäuseoberteiles 22 Modul-Aufnahme ausgebildet, in die die verschiedenen Schaltungsmodule einzusetzen sind, beispielsweise eine Modulplatte 57 mit den primärseitigen Schaltungsteilen 61 und eine zweite Modulplatte 58 mit den sekundärseitigen Schaltungsteilen 64 und den Anschlüssen 65 zu den Anschlußklemmen 25. Auf der Modulplatte 57 sind der Ein-/Ausschalter 62 und ein Batterie-Prüfschalter 63 direkt angebracht. Diese Schalter 62 und 63 sind als Druckschalter ausgebildet, wobei der Ein-/Ausschalter zwei stabile Schalterstellungen aufweist und der Batterie-Prüfschalter 63 nur so lange in der Prüfschaltstellung verbleibt, solange er eingedrückt ist und beim Loslassen in seine Normalstellung zurückgeht. Die Modulplatte 57 wird durch ein auf ihre Unterseite greifendes, buchsenförmiges Halter- und Pufferelement 52, 53 in ihrer Lage gehalten. Dieses buchsenförmige Halter- und Pufferelement umgibt die auf der Modulplatte 57 angebrachten Anschlußstifte 66 auf die die Anschlußklemmen der als Stromquelle dienenden Trockenbatterie 70 zu stecken sind. Diesem Halter- und Pufferelement 53 liegen Modul-Aufnahmeelemente 54 gegenüber. Am rückwärtigen Rand liegt die Modulplatte 57 gegen an der Innenseite der Deckenwand 60 angeformte Widerlagerelemente 67, die den auf den Ein-/Ausschalter 62 bzw. den Batterie-Prüfschalter 63 ausgeübten axialen Betätigungsdruck abstützen.

Die die sekundärseitigen Schaltungsteile aufnehmende Modulplatte 58 ist mittels Klemmhalterleisten 59 gehalten. Sie trägt im mittleren Bereich hinten einer Öffnung eine Glimmlampe 68, die kurzfristig aufleuchtet, wenn an den Anschlußklemmen 25 ein Hochspannungsimpuls anliegt, der die erforderliche Mindestspannung aufweist.

Wie die Figuren 15 und 18 ferner zeigen, sind in der Umfangswand des Gehäuseoberteiles 22 abgedichtete Schaugläser 69 vor den Kontrollampen 24 und 68 angebracht.

Ferner zeigen die Figuren 15 und 18 andeutungsweise den Impulstransformator 56, der durch Halter- und Pufferelemente 51 in seiner entsprechenden Modulaufnahme gehalten ist.

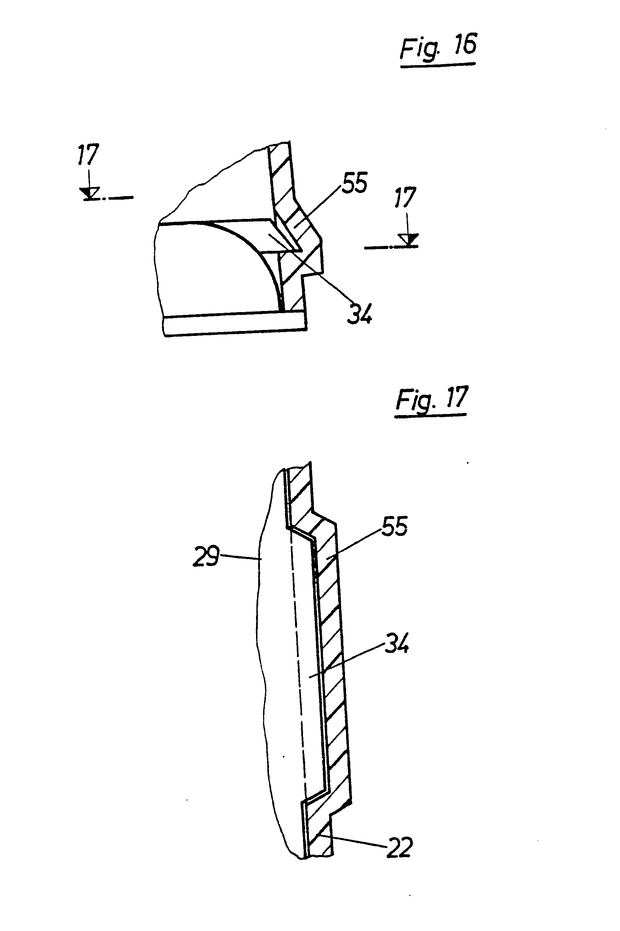

Im Beispiel gemäß den Figuren 15 bis 20 ist für die Rastrippen 34 des Zwischenbodens 29 eine rippenförmige Vorstülpung 55 in den stirnseitigen Umfangswandteilen des Gehäuseoberteiles 22 ausgebildet. Diese Vorstülpungen 55 bilden je einen unteren Auflagerand für die Rastrippen 34 des Zwischenbodens 29. Um den Zwischenboden 29 aus dem deckelartigen Gehäuseoberteil 22 herauszunehmen, müssen die stirnseitigen Umfangswandteile des Gehäuseoberteiles 22 in ihrem mittleren Bereich nach außen verformt werden. Das Zusammengreifen der Rastrippen 34 am Zwischenboden 29 mit den Vorstülpungen 55 an dem Gehäuseoberteil 22 wird aus den Detaildarstellungen der Figuren 16 und 17 deutlich. Gegenüber den gemäß Figur 4 vorgesehenen Aufnahmeschlitzen 34 des Zwischenbodens 29 bieten die Vorstülpungen 55 den Vorteil, daß der die elektrischen Schaltungsteile aufnehmende Innenraum des Gehäuseoberteiles 22 besser abgedichtet ist, so daß nicht Wasser, auch nicht Spritzwasser, dort eindringen kann.

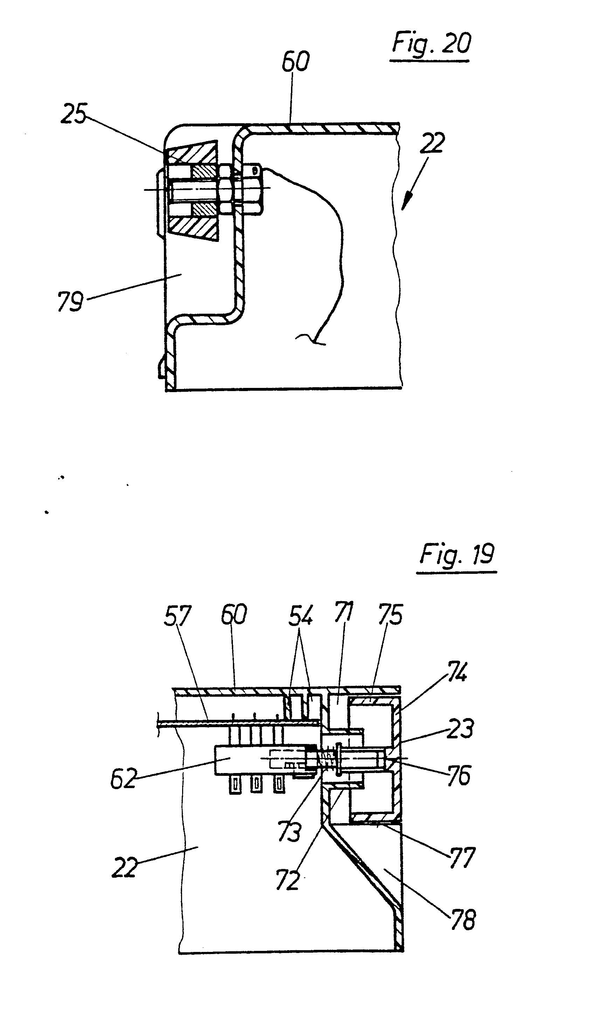

Wie aus Figur 19 deutlicher erkennbar, ist im Bereich des Ein-/Ausschalters 62 an der Außenseite des Gehäuseoberteils 22 unmittelbar unter dessen Deckenwand 60 eine der Querschnittsform des Betätigungsknopfes 23 angepaßte Aufnahme 71 in Form einer Vertiefung ausgebildet. Im mittleren Bodenbereich dieser Aufnahme 71 ist eine in die Aufnahme 71 vorstehende Labyrinthbuchse 72 angeformt. In diese Labyrinthbuchse 72 erstreckt sich das stiftförmige Betätigungsteil 73 des Ein-/Ausschalters 62. Der Betätigungsknopf 23 ist mit einer Stirnwand 74, einer Umfangswand 75 und einem mittigen, rückwärtigen Verbindungsschaft 76 ausgebildet, der auf das Betätigungsteil 73 des Schalters 62 zu stecken ist. Zwischen dem Verbindungsschaft 76 und der Umfangswand 75 ist an der Rückseite des Betätigungsknopfes 23 ein ringförmiger Hohlraum gebildet, in den die Labyrinthbuchse 72 zur Bildung einer Labyrinthdichtung in Überlappung mit dem Verbindungsschaft 76 und der Umfangswand 75 hineinragt. Die Umfangswand 75 bildet mit der Umfangsfläche der Aufnahme 71 einen engen Schlitz 77, der zur sicheren, beweglichen Führung des Betätigungsknopfes 23 ausreicht, aber auch bei starkem Besprtzen mit Wasser, beispielsweise bei Regen und Sturm, kaum nennenswerte Wassermengen durchtreten läßt. Für alle Fälle ist aber zur Entleerung der Aufnahme 71 in der Wandung des Gehäuseoberteiles 22 ein rinnenförmiger Wasserablauf 78 ausgebildet, der vom Boden der Aufnahme 71 auf die Außenfläche des Gehäuseoberteiles 22 führt. Die gleiche Ausbildung von Aufnahme und Betätigungsknopf sowie Labyrinthabdichtung ist auch für den in Figur 16 gezeigten Batterie-Prüfschalter 63 vorgesehen. Dabei sind der Ein-/Ausschalter 62 und der Batterie-Prüfschalter 63 bzw. ihre Betätigungsknöpfe 23 an den oberen, äußeren Eckbereichen der einen Stirnseite des Gehäuseoberteiles 22 angeordnet.

Wie Figur 20 zeigt, wird eine verbesserte Anordnung der sekundärseitigen Anschlußklemmen dadurch erreicht, daß an der den Aufnahmen 71 für die Betätigungsknöpfe 23 gegenüberliegenden Stirnseite des Gehäuseoberteiles 22 Mulden 79 ebenfalls in den oberen, äußeren Eckbereichen ausgebildet sind. Diese Mulden sind nach der Oberseite und nach der jeweiligen Seitenfläche des Gehäuseoberteiles 22 hin offen. Die Tiefe dieser Mulden 79 entspricht im wesentlichen der Höhe der festgeschraubten Anschlußklemmen 25.

Die an der Oberseite des Zwischenbodens 29 und an der Innenfläche der Deckenwand 60 ausgebildeten Halter- und Pufferelemente können naturgemäß den jeweiligen Anforderungen für das Zusammenhalten der jeweils benutzten zusammensteckbaren und in den entsprechenden Modulaufnahmen festzuhaltenden Schaltungsmodule angepaßt sein. Dadurch bietet das Gerätegehäuse 20 besonders günstige Möglichkeiten für den Aufbau der elektrischen Schaltungsanordnung aus Schaltungsmodulen, die lediglich in die jeweils vorgesehenen Modul-Aufnahmen einzulegen und mittels anzusteckender Verbindungsleitungen elektrisch miteinander zu verbinden sind. Außer den Halter- und Pufferelementen bedarf es keiner sonstigen Befestigungseinrichtungen mehr für diese Schaltungsmodule.

Wie die Figuren 1 und 3 zeigen, ist das Gehäuseunterteil 21 derart auf die aufzunehmende Stromquelle, vorzugsweise eine Trockenbatterie abgestimmt, daß sich die Stromquelle bzw. Trockenbatterie bis dicht an den Öffnungsrand des Gehäuseunterteils 21 heran erstreckt, und zwar bis innerhalb des in die Öffnung des Gehäuseunterteils 21 hineinragenden Umfangswandteiles 30 hinein. Hierdurch wird eine sichere Abdeckung des oberen Randes der Stromquelle 70 in Art einer Labyrinthdichtung geschaffen. Für den Fall, daß eine Stromquelle 70' kleinerer Abmessungen vorgesehen ist, sind entsprechende Einsatzteile 80 — wie in Figur 3 angedeutet — zu benutzen.

Bezugszeichenliste

20 Gerätegehäuse
21 Gehäuseunterteil
22 Gehäuseoberteil
23 Betätigungsknöpfe
24 Kontrollampen
25 Anschlußklemmen

26 Schiebeverschluß
27 Abziehsicherung
28 Tragegriff
29 Zwischenboden
30 Umfangswand
31 Flansch
32 Stirnfläche
33 Stirnfläche
34 Rippe
35 Schlitz
36 Keilverschlußleisten
36' Keilverschlußleisten
37 Keilverschlußleisten
37' Keilverschlußleisten
38 Schließklammern
39 Schnapphaken
40 Widerlager- und Rückhalteplatte
41 Aufnahmekammer
42 Pfeil
43 Pfeil
44 Pfeil
45 Bügel
46 keilförmige Vorsprünge
46' keilförmige Vorsprünge
46a Ausnehmung in 46'
47 Ausformungen
47' Ausformungen
48 Ausformungen
48' Ausformungen
48a innere Nocken
49 Nuten
50 Pufferelement
51 Pufferelement
52 Pufferelement
53 Pufferelement
54 Modulaufnahme
55 Vorstülpung
56 Impulstransformator
57 Modulplatte (primärseitig)
58 Modulplatte (sekundärseitig)
59 Klemmhalter für 58
60 Deckenwand von 22
61 primärseitige Schaltungsteile
62 Ein-Aus-Schalter
63 Batterie-Prüfschalter
64 sekundärseitige Schaltungsteile
65 Anschluß an 58
66 Anschlußstifte an 57
67 Widerlagerelement
68 Kontrollampe (Ausgangsimpuls)
69 Schauglas
70 Trockenbatterie
71 Aufnahme
72 Labyrinthbuchse
73 Betätigungsteil von 62 und 63
74 Stirnwand von 23
75 Umfangswand von 23
76 Verbindungsschaft von 23
77 Schlitz zwischen 71 und 75
78 Wasserablauf an 71
79 Aufnahmemulde für 25
80 Einsatzteile

**Patentansprüche**

1. Spritzwassergeschütztes elektrisches Gerät, vorzugsweise Elektrozaungerät, dessen Gehäuse (20) für gemeinsame Unterbringung einer Stromquelle (70, 70'), beispielsweise Trockenbatterie, und einer elektrischen Schaltungsanordnung ein behälterartiges Gehäuseunterteil (21) zur Aufnahme der Stromquelle (70, 70') und ein im wesentlichen deckelartiges Gehäuseoberteil (22) zur Aufnahme der elektrischen Schaltungsteile aufweist, wobei sich das Gehäuseunterteil (21) in einem streifenförmigen Bereich seines Öffnungsrandes zur spritzwassergeschützten Abdichtung ringsum mit einem am Gehäuseoberteil (22) vorgesehenen, flanschartigen Umfangswandteil (30) überlappt und an der Außenseite des Gehäuseunterteiles (21) und des Gehäuseoberteiles (22) Verschlußelemente angebracht sind, dadurch gekennzeichnet, daß die Verschlußelemente als sich am Gehäuseunterteil (21) parallel zu dessen Öffnungsrand erstreckende untere Verschlußleisten (37) und am Gehäuseoberteil (22) sich parallel zu dessen unteren Rand erstreckende obere Verschlußleisten (36), die sich bei zusammengesetztem Gehäuse (20) auf die unteren Verschlußleisten (37) setzen, sowie jeweils über ein aufeinandergesetztes Paar von unteren und oberen Verschlußleisten (37, 36) steckbare, mit Abziehsicherung (27) ausgestattete Schließklammern (38) ausgebildet sind, und daß der flanschartige Umfangswandteil (30) des Gehäuseoberteiles (22) als spritzwassergeschützte Abdichtung in den Öffnungsrand des Gehäuseunterteils (21) greift und in das Innere des Gehäuseunterteils (22) führende, labyrinthartig ausgebildete Lufteinlässe (49) aufweist.

2. Gerät nach Anspruch 1, dadurch gekennzeichnet, daß das Gehäuseoberteil (22) in Art eines Stülpdeckels mit Umfangswand und unterem Öffnungsrand ausgebildet und der sich mit dem Öffnungsrandbereich des Gehäuseunterteiles (21) überlappende Umfangswandteil am Gehäuseoberteil (22) die Umfangswand (30) eines in das Gehäuseoberteil (22) eingesetzten Zwischenbodens (29) ist, wobei diese Umfangswand (30) des Zwischenbodens (29) in den Öffnungsquerschnitt des Gehäuseunterteiles (21) und den Öffnungsquerschnitt des Gehäuseoberteiles (22) passend ausgebildet ist und Einrichtungen (34, 35 bzw. 55) zum Verrasten im Gehäuseoberteil (22) in solcher Lage aufweist, in welcher die Umfangswand (30) des Zwischenbodens (29) gegenüber dem Umfangsrand des Gehäuseoberteiles (22) axial vorsteht.

3. Gerät nach Anspruch 1 oder 2, dadurch gekennzeichnet, daß die Verschlußleisten als seitlich an den Gehäuseteilen (21, 22) vorstehende Keilverschlußleisten (36, 37) ausgebildet sind.

4. Gerät nach einem der Ansprüche 1 bis 3, dadurch gekennzeichnet, daß das Gehäuseoberteil (22) und das Gehäuseunterteil (21) Keilverschlußleisten (36, 37 ; 36', 37') jeweils als Hälften eines oder mehrerer Keile tragen, die bei seitenrichtigem Zusammensetzen beider Gehäuseteile (21, 22) jeweils einen vollständigen Keil bilden, und über diesen Keil formschlüssig eine als Keilhülse ausgebildete Schließklammer (38, 38') gezogen wird.

5. Gerät nach Anspruch 3 oder 4, dadurch gekennzeichnet, daß die Keilverschlußleisten (36, 37, 36', 37') in die Wand des Gehäuseoberteiles (22) und die Wand des Gehäuseunterteils (21) eingeformt sind und in die Umfangswand (30) des Zwischenbodens (29) in die durch diese Keilverschlußleisten (36, 37 ; 36', 37') gebildete rückwärtige Wandausformungen (47, 48 ; 47', 48') passende Vorsprünge (46, 46') geformt sind.

6. Gerät nach einem der Ansprüche 2 bis 5, dadurch gekennzeichnet, daß die Umfangswand (30) des Zwischenbodens (29) in vorgegebener Höhe, beispielsweise im wesentlichen mittlerer Höhe, einen nach außen vorstehenden Flansch (31) aufweist, der sich bündig zwischen die Stirnflächen der Wände des Gehäuseunterteils (21) und des Gehäuseoberteils (22) legt.

7. Gerät nach einem der Ansprüche 1 bis 6, dadurch gekennzeichnet, daß die Schließklammern (38) mit einem bei vollständigem Aufziehen auf die Verschlußleisten, beispielsweise Keilverschlußleisten (36, 37) hinter entsprechend vorstehende Teile (40) am Gehäuse (20) greifenden Schnapphaken (39) als Abziehsicherung versehen sind.

8. Gerät nach einem der Ansprüche 1 bis 7, dadurch gekennzeichnet, daß an zwei sich gegenüberliegenden Wandbereichen des Gehäuses (20) je ein Paar von Keilverschlußleisten (36, 37) angeordnet ist und zwei Schließklammern (38) über einen Bügel (45) miteinander verbunden sind, der als sich mit Abstand über den Geräteoberteil (22) erstreckender Tragegriff (28) ausgebildet ist.

9. Gerät nach einem der Ansprüche 2 bis 8, dadurch gekennzeichnet, daß am oberen Rand mindestens zweier sich gegenüberliegender Bereiche der Zwischenboden-Umfangswand (30) nach außen vorspringende horizontale Rippen (34) oder Nasen und in den entsprechenden Wandbereichen des Gehäuseoberteiles (22) entsprechende Aufnahmen (35 bzw. 55) ausgebildet sind.

10. Gerät nach einem der Ansprüche 2 bis 9, dadurch gekennzeichnet, daß an der Umfangswand (30) des Zwischenbodens (29) als Lufteinlässe, beispielsweise im Bereich unterhalb der horizontalen Rippen (34) bzw. Nasen, in den Innenraum des Gehäuseunterteiles (21) führende, vertikale Nuten (49) ausgebildet sind.

11. Gerät nach einem der Ansprüche 2 bis 10, dadurch gekennzeichnet, daß der Zwischenboden (29) an der Unterseite Pufferelemente (50) trägt, die sich auf der Stromquelle abstützen.

12. Gerät nach einem der Ansprüche 2 bis 11, dadurch gekennzeichnet, daß der Zwischenboden (29) an der Oberseite Pufferelemente (51, 52, 53) trägt, die sich gegen die im Gehäuseoberteil (22) untergebrachten elektrischen Schaltungsteile setzen.

13. Gerät nach Anspruch 12, dadurch gekennzeichnet, daß die elektrische Schaltungsanordnung in Form mehrerer Schaltungsmodule mit Steckverbindungen aufgebaut ist und die an der Oberseite des Zwischenbodens (29) angebrachten Pufferelemente (51, 52, 53) als Halteeinrichtung zum Zusammenhalten der zusammengesteckten Schaltungsmodule ausgebildet sind, wobei die Schaltungsmodule in entsprechende Aufnahmen (54) im Gehäuseoberteil (22) lediglich eingelegt und bei im Gehäuseoberteil (22) eingesetztem und verrastetem Zwischenboden (29) von dessen oberseitigen Pufferelementen (51, 52, 53) in diesen Aufnahmen gehalten sind.

14. Gerät nach einem der Ansprüche 1 bis 13, dadurch gekennzeichnet, daß die elektrische Schaltungsanordnung mindestens ein in das Gehäuseoberteil (22) eingesetztes Schaltungsmodul (57) enthält, an dem mindestens ein von außen her betätigbarer Schalter (62) und bzw. oder eine von außen betätigbare Regel- oder Prüfeinrichtung (63) unmittelbar angebracht ist und mit seinem bzw. ihrem das Betätigungselement (23) tragenden Betätigungsteil (73) durch eine Labyrinthdichtung spritzwassergeschützt auf die Außenseite des Gehäuseoberteiles (22) ragt.

15. Gerät nach Anspruch 14, dadurch gekennzeichnet, daß das Bedienungselement ein mit Stirnwand (74), Umfangswand (75) und mittlerem, rückwärtigem Verbindungsschacht (76) ausgebildeter Druck- oder Drehknopf (23) ist, der mit seinem Umfang passend in einer am Gehäuseoberteil (22), vorzugsweise dessen Umfangswand als Vertiefung ausgebildeten Aufnahme (71) bewegbar angebracht ist.

16. Gerät nach Anspruch 14 oder 15, dadurch gekennzeichnet, daß die Labyrinthdichtung durch eine in der Bodenwand der Aufnahme (71) vorgesehene und sich mit der Umfangswand (75) des Druck- oder Drehknopfes (23) überlappende Labyrinthbuchse (72) gebildet ist, die den Betätigungsteil (73) des Schalters (62) bzw. der Regel- oder Prüfeinrichtung (63) und den Verbindungsschaft (76) des Druck- oder Drehknopfes (23) aufnimmt.

17. Gerät nach Anspruch 15 oder 16, dadurch gekennzeichnet, daß die als Vertiefung in der Wand, vorzugsweise Umfangswand, des Gehäuseoberteiles (22) ausgebildete Aufnahme (71) einen auf die Gehäuse-Außenseite führenden Wasserablauf (78) aufweist.

18. Gerät nach einem der Ansprüche 14 bis 17, dadurch gekennzeichnet, daß die im Gehäuseoberteil (22) untergebrachten Schaltungsteile, insbesondere Schaltungsmodule (57, 58), einen Feuchtigkeits-Schutz aufweisen.

19. Gerät nach einem der Ansprüche 1 bis 18, dadurch gekennzeichnet, daß elektrische Anschlußklemmen (25) in am Gehäuseoberteil (22) ausgebildeten Mulden (79) angeordnet sind.

20. Gerät nach einem der Ansprüche 14 bis 19, dadurch gekennzeichnet, daß die Aufnahmen (71) für die Bedienungselemente (23) für elektrische Schalter (62) und bzw. oder Regel- oder Prüfeinrichtungen (63) an der einen Stirnseite des Gehäuseoberteiles (22) unmittelbar unterhalb dessen Deckenwand (60) angeordnet und die die Anschlußklemmen (25) aufnehmenden Mulden (79) in den oberen Eckbereichen der gegenüberliegenden Stirnwand des Gehäuseoberteiles (22) gebildet sind.

21. Gerät nach einem der Ansprüche 1 bis 20, dadurch gekennzeichnet, daß das Gehäuseunterteil (21) ggf. mittels zusätzlicher Einsätze (80) dazu ausgebildet ist, daß eine eingesetzte Stromquelle (70, 70') mit ihrem oberen Rand in den innerhalb des Umfangswandteiles (30) am Gehäuseoberteil (22) gebildeten Hohlraum ragt.

**Claims**

1. Splashproof electrical apparatus, preferably an electric fence apparatus, in which for the purpose of accommodating a current source (70, 70'), for example a dry battery, and at the same time an electric circuit arrangement, the casing (20) comprises a container-like lower casing part (21) to receive the current source (70, 70') and a substantially lid-like upper casing part (22) to receive the electric circuit parts, while for the purpose of providing splashproof sealing the lower casing part (21) overlaps, in a strip-like region of its opening rim, a flange-like peripheral wall part (30) extending around the upper casing part (22), and on the outside of the lower casing part (21) and of the upper casing part (22) closure members are provided, characterized in that the closure members are in the form of lower closure strips (37) extending on the lower casing part (21) parallel to the opening rim of the latter and of upper closure strips (36) which extend on the upper casing part (22) parallel to the bottom rim of the latter and which when the casing (20) is assembled are placed onto the lower closure strips (37), and further of respective closure clips (38) adapted to be disposed over a respective pair of lower and upper closure strips (37, 36) placed one over the other, said clips being equipped with securing means (27), and that the flange-like peripheral wall part (30) of the upper casing part (22) engages as a splashproof sealing means in the opening rim of the lower casing part (21) and has labyrinth-like air inlets (49) leading into the interior of the lower casing part (22).

2. Apparatus according to Claim 1, characterized in that the upper casing part (22) is formed after the style of a cuffed lid having a peripheral wall and bottom opening rim, and that the peripheral wall part provided on the upper casing part (22) and overlapping the opening rim region of the lower casing part (21) is the peripheral wall part (30) of an intermediate floor (29) inserted in the upper casing part (22), said peripheral wall (30) of the intermediate floor (29) being constructed to fit into the opening cross-section of the lower casing part (21) and the opening cross-section of the upper casing part (22) and being provided with devices (34, 35 or 55) for locking in the upper casing part (22) in a position in which the peripheral wall (30) of the intermediate floor projects axially in relation to the peripheral rim of the upper casing part (22).

3. Apparatus according to Claim 1 or 2, characterized in that the closure strips are in the form of wedge closure strips (36, 37) projecting laterally on the casing parts (21, 22).

4. Apparatus according to one of Claims 1 to 3, characterized in that the upper casing part (22) and the lower casing part (21) carry wedge closure strips (36, 37 ; 36', 37') forming in each case halves of one or more wedges which in each case form a complete wedge when the two casing parts (21, 22) are assembled true-to-side, and that a closure clip (38, 38') in the form of a wedge sleeve is pulled with a positive locking action over said wedge.

5. Apparatus according to Claim 3 or 4, characterized in that the wedge closure strips (36, 37, 36', 37') are formed in the wall of the upper casing part (22) and the wall of the lower casing part (21), and that projections (46, 46') fitting into the rear wall formations (47, 48 ; 47', 48' formed by these wedge closure strips (36, 37 ; 36', 37') are formed in the peripheral wall (30) of the intermediate floor (29).

6. Apparatus according to one of Claims 2 to 5, characterized in that the peripheral wall (30) of the intermediate floor (29) is provided at a predetermined height, for example substantially at mid-height, with an outwardly projecting flange (31) which lies flush between the end faces of the walls of the lower casing part (21) and of the upper casing part (22).

7. Apparatus according to one of Claims 1 to 6, characterized in that the closure clips (38) are provided with a snap hook (39) which when fully pulled over the closure strips, for example wedge closure strips (36, 37), engages behind correspondingly projecting parts (40) on the casing (20) and which serves as anti-pull-off securing means.

8. Apparatus according to one of Claims 1 to 7, characterized in that in each of two oppositely situated wall regions of the casing (20) there is disposed a pair of wedge closure strips (36, 37), and that two closure clips (38) are joined together by a bow (45) which is in the form of a carrying handle (28) extending over and spaced apart from the upper casing part (22).

9. Apparatus according to one of Claims 2 to 8, characterized in that on the top edge of at least two oppositely situated regions of the peripheral wall (30) of the intermediate floor there are formed outwardly projecting horizontal ribs (34) or noses, and that corresponding seats (35 and 55 respectively) are formed in the corresponding wall regions of the upper casing part (22).

10. Apparatus according to one of Claims 2 to 9, characterized in that vertical slots (49) leading into the interior of the lower casing part (21) are formed in the peripheral wall (30) of the intermediate floor (29), for example in the region below the horizontal ribs (34) or noses to serve as air inlets.

11. Apparatus according to one of Claims 2 to 10, characterized in that the intermediate floor (29) carries on its lower side buffer members (50) which are supported on the current source.

12. Apparatus according to one of Claims 2 to 11, characterized in that the intermediate floor (29) carries on its upper side buffer members (51, 52, 53) which lie against the electric circuit parts accommodated in the upper casing part (22).

13. Apparatus according to Claim 12, characterized in that the electric circuit arrangement is constructed in the form of a plurality of circuit modules with plug-in connections and that the buffer members (51, 52, 53) provided on the upper side of the intermediate floor (29) are in the form of a holding device for holding together the switch modules plugged into one another, while the circuit modules are simply inserted into corresponding seats (54) in the upper casing part (22) and when the intermediate floor (29) is inserted into the upper casing part (22) and locked said circuit modules are held in said seats by the buffer members provided on the upper side of said intermediate floor.

14. Apparatus according to one of Claims 1 to 13, characterized in that the electric circuit arrangement contains at least one circuit module (57) which is inserted into the upper casing part (22) and on which at least one switch (62) adapted to be operated from outside and/or a control or testing device (63) is or are mounted direct and projects or project by its or their operating part (73) carrying the operating member (23), with splash-proof protection, through a labyrinth seal onto the outer side of the upper casing part (22).

15. Apparatus according to Claim 14, characterized in that the operating member is a push-button or rotary knob (23) which is constructed with a front wall (74), peripheral wall (75), and central rear connecting casing (76) and which is mounted movably with its periphery fitting into a seat (71) formed as a depression in the upper casing part (22), preferably in its peripheral wall.

16. Apparatus according to Claim 14 or 15, characterized in that the labyrinth seal is formed by a labyrinth bush (72) formed in the bottom wall of the seat (71) and overlapping with the peripheral wall (75) of the push-button or rotary knob (23), said bush receiving the operating part (73) of the switch (62) or control or testing device (63) and the connecting casing (76) of the push-button or rotary knob (23).

17. Apparatus according to Claim 15 or 16, characterized in that the seat (71) formed as a depression in the wall, preferably the peripheral wall, of the upper casing part (22) has a water outlet (78) leading to the outside of the casing.

18. Apparatus according to one of Claims 14 to 17, characterized in that the circuit parts accommodated in the upper casing part (22), particularly circuit modules (57, 58), are protected against moisture.

19. Apparatus according to one of Claims 1 to 18, characterized in that electric connection terminals (25) are disposed in troughs (79) formed in the upper casing part (22).

20. Apparatus according to one of Claims 14 to 19, characterized in that the seats (71) for the operating members (23) for electric switches (62) and/or control or testing devices (63) are disposed on one end face of the upper casing part (22) directly under its cover wall (60), and the troughs (79) receiving the connection terminals (25) are formed in the upper corner regions of the opposite end wall of the upper casing part (22).

21. Apparatus according to one of Claims 1 to 20, characterized in that the lower casing part (21) is constructed, optionally with the aid of additional inserts (80), to enable a inserted current source (70, 70') to project by its top edge into the cavity formed inside the peripheral wall part (30) on the upper casing part (22).

## Revendications

1. Appareil électrique protégé contre les projections d'eau, de préférence appareil de clôture électrique, dont le boîtier (20), en vue du logement commun d'une source de courant (70, 70'), par exemple d'une batterie sèche, et d'un montage de circuit électrique, comporte une partie inférieure en forme de récipient (21) destinée à recevoir la source de courant (70, 70') et une partie supérieure essentiellement en forme de couvercle (22) destinée à recevoir les composants de circuit électrique, la partie inférieure (21) du boîtier chevauchant, dans une zone en forme de bande du bord de son orifice et tout autour de celui-ci, en vue d'assurer l'étanchéité aux projections d'eau, une partie de paroi périphérique en forme de jupe (30) prévue sur la partie supérieure (22) du boîtier et des éléments de fermeture étant prévus sur le côté extérieur de la partie inférieure (21) et de la partie supérieure (22) du boîtier, caractérisé en ce que les éléments de fermeture ont la forme de languettes de fermeture inférieures (37) qui s'étendent sur la partie inférieure (21) du boîtier parallèlement au bord de l'orifice de celle-ci et de languettes de fermeture supérieures (36) qui s'étendent sur la partie supérieure (22) du boîtier parallèlement au bord inférieur de celle-ci et qui, lorsque le boîtier (20) est assemblé, s'appliquent sur les languettes de fermeture inférieures (37), ainsi que de chapes de fermeture (38) pouvant être glissées chacune sur une paire de languettes de fermeture supérieures et inférieures superposées et équipées d'une sécurité de déblocage (27), et que la partie de paroi périphérique (30) en forme de jupe de la partie supérieure (22) du boîtier s'engage, à titre d'organe d'étanchéité protégé contre les projections d'eau, dans le bord de l'orifice de la partie inférieure (21) du boîtier et présente des moyens d'admission d'air (49) en forme de labyrinthes qui aboutissent à l'intérieur de la partie inférieure (22) du boîtier.

2. Appareil suivant la revendication 1, caractérisé en ce que la partie supérieure (22) du boîtier a la forme d'un couvercle en cloche qui comporte une paroi périphérique et un bord d'orifice inférieur et la partie de paroi périphérique de la partie supérieure (22) du boîtier qui chevauche la zone du bord de l'orifice de la partie inférieure (21) du boîtier est la paroi périphérique (30) d'un fond intermédiaire (29) inséré dans la partie supérieure (22) du boîtier, cette paroi périphérique (30) du fond intermédiaire (29) étant ajustée dans la section de l'orifice de la partie inférieure (21) du boîtier et dans la section de l'orifice de la partie supérieure (22) du boîtier et comportant des dispositifs (34, 35, 55) pour assurer le verrouillage dans la partie supérieure (22) du boîtier dans une position dans laquelle la paroi périphérique (30) du fond intermédiaire (29) fait saillie axialement par rapport au bord périphérique de la partie supérieure (22) du boîtier.

3. Appareil suivant la revendication 1 ou 2, caractérisé en ce que les languettes de fermeture ont la forme de languettes de fermeture par clavetage (36, 37) latéralement en saillie sur les parties (21, 22) du boîtier.

4. Appareil suivant l'une quelconque des revendications 1 à 3, caractérisé en ce que la partie supérieure (22) du boîtier et la partie inférieure (21) du boîtier portent des languettes de fermeture par clavetage (36, 37 ; 36', 37') qui ont chacun la forme de moitiés d'une ou de plusieurs clavettes qui, lors d'un assemblage latéralement correct des deux parties de boîtier (21, 22), forment chaque fois une clavette complète, par-dessus laquelle une chape de fermeture (38, 38') en forme d'étui de clavetage est tirée d'une manière assurant un épousement de forme.

5. Appareil suivant la revendication 3 ou 4, caractérisé en ce que les languettes de fermeture par clavetage (36, 37 ; 36', 37') sont venues d'une pièce dans la paroi de la partie supérieure (22) et dans la paroi de la partie inférieure (21) du boîtier et, dans la paroi périphérique (30) du fond intermédiaire (29) dans les renfoncements de paroi (47, 48 ; 47', 48') formés par ces languettes de fermeture par clavetage (36, 37 ; 36', 37'), sont formées des saillies adaptées (46, 46').

6. Appareil suivant l'une quelconque des revendications 2 à 5, caractérisé en ce que la paroi périphérique (30) du fond intermédiaire (29) présente, à un niveau prédéfini, par exemple en substance à mi-hauteur, une bride (31) en saillie vers l'extérieur qui s'ajuste entre les faces d'about des parois de la partie inférieure (21) et de la partie supérieure (22) du boîtier, au ras de celles-ci.

7. Appareil suivant l'une quelconque des revendications 1 à 6, caractérisé en ce que les chapes de fermeture (38) sont pourvues, à titre de sécurité de déblocage, de crochets formant déclic (39) qui, lorsque les chapes sont tirées à fond sur les languettes de fermeture, par exemple les languettes de fermeture par clavetage (36, 37), s'accrochent derrière des saillies correspondantes (40) sur le boîtier (20).

8. Appareil suivant l'une quelconque des revendications 1 à 7, caractérisé en ce qu'une paire de languettes de fermeture par clavetage (36, 37) est chaque fois disposée sur deux zones de paroi opposées de l'enveloppe (20) et deux chapes de fermeture (38) sont reliées l'une à l'autre par une anse (45) qui a la forme d'une poignée de support (28) s'étendant à une certaine distance au-dessus de la partie supérieure (22) du boîtier de l'appareil.

9. Appareil suivant l'une quelconque des revendications 2 à 8, caractérisé en ce que sur le bord supérieur d'au moins deux zones opposées de la paroi périphérique (30) du fond intermédiaire sont formés des nervures horizontales (34) ou des becs en saillie vers l'extérieur et dans les zones de paroi correspondantes de la partie supérieure (22) du boîtier sont formés des logements correspondants (35 ou 55).

10. Appareil suivant l'une quelconque des revendications 2 à 9, caractérisé en ce que dans la paroi périphérique (30) du fond intermédiaire (29), à titre de moyens d'admission d'air, des rainures verticales (49) débouchant dans le volume intérieur de la partie inférieure (21) du boîtier sont ménagées, par exemple dans la zone située en dessous des nervures horizontales (34) ou des becs.

11. Appareil suivant l'une quelconque des revendications 2 à 10, caractérisé en ce que le fond intermédiaire (29) porte, sur sa face inférieure, des éléments formant tampons (50) qui prennent appui sur la source de courant.

12. Appareil suivant l'une quelconque des revendications 2 à 11, caractérisé en ce que le fond intermédiaire (29) porte, au niveau de sa face supérieure, des éléments formant tampons (51, 52, 53) qui s'appliquent contre les composants de circuit électrique logés dans la partie supérieure (22) du boîtier.

13. Appareil suivant la revendication 12, caractérisé en ce que le montage de circuit électrique a la forme de plusieurs modules de circuit pourvus de connexions enfichables et les éléments formant tampons (51, 52, 53) montés sur la face supérieure du fond intermédiaire (29) ont la forme d'un dispositif de retenue destiné à maintenir les modules de circuit enfichés, les modules de circuit étant simplement insérés dans des logements (54) correspondants dans la partie supérieure (22) du boîtier et étant maintenus dans ces logements lorsque le fond intermédiaire (29) est inséré et verrouillé dans la partie supérieure (22) du boîtier par les éléments formant tampons (51, 52, 53) de sa face supérieure.

14. Appareil suivant l'une quelconque des revendications 1 à 13, caractérisé en ce que le montage de circuit électrique comprend au moins un module de circuit (57) inséré dans la partie supérieure (22) du boîtier, sur lequel au moins un interrupteur (62) pouvant être manœuvré de l'extérieur et/ou un dispositif de réglage ou de contrôle (63) pouvant être manœuvré de l'extérieur sont directement montés et s'étendent par leur partie d'actionnement (73) portant l'organe d'actionnement (23) à travers un joint d'étanchéité à labyrinthe protégé contre les projections d'eau, à l'extérieur de la partie supérieure (22) du boîtier.

15. Appareil suivant la revendication 14, caractérisé en ce que l'élément de manœuvre est un bouton-poussoir ou un bouton tournant (23) comportant une paroi d'about (74), une paroi périphérique (75) et une tubulure de jonction postérieure centrale (76), dont la périphérie s'ajuste dans un logement (71) en forme de renfoncement dans la partie supérieure (22) du boîtier, de préférence dans sa paroi périphérique, dans lequel il est monté mobile.

16. Appareil suivant la revendication 14 ou 15, caractérisé en ce que le joint d'étanchéité à labyrinthe est formé par une douille de labyrinthe (72) qui est prévue dans la paroi de fond du logement (71) et chevauche la paroi périphérique (75) du bouton-poussoir ou tournant (23), et qui reçoit l'organe d'actionnement (73) du commutateur (62) ou du dispositif de réglage ou de contrôle (63) ainsi que l'axe de liaison (76) du bouton-poussoir ou tournant (23).

17. Appareil suivant la revendication 15 ou 16, caractérisé en ce que le logement (71) ayant la forme d'un renfoncement dans la paroi, de préférence la paroi périphérique de la partie supérieure (22) du boîtier, présente un orifice d'évacuation d'eau (78) s'ouvrant à l'extérieur du boîtier.

18. Appareil suivant l'une quelconque des revendications 14 à 17, caractérisé en ce que les composants de circuit logés dans la partie supérieure (22) du boîtier, en particulier les modules de circuit (57, 58), présentent une protection contre l'humidité.

19. Appareil suivant l'une quelconque des revendications 1 à 18, caractérisé en ce que des bornes électriques (25) sont disposées dans des cavités (79) formées dans la partie supérieure (22) du boîtier.

20. Appareil suivant l'une quelconque des revendications 14 à 19, caractérisé en ce que les logements (71) pour les éléments de manœuvre (23) prévus pour des commutateurs électriques (62) et/ou des dispositifs de réglage ou de contrôle (63) sont disposés sur la première face d'about de la partie supérieure (22) du boîtier directement en dessous de sa paroi supérieure (60) et les cavités (69) recevant les bornes (25) sont formées dans les coins supérieurs de la paroi d'about opposée de la partie supérieure (22) du boîtier.

21. Appareil suivant l'une quelconque des revendications 1 à 20, caractérisé en ce que la partie inférieure (21) du boîtier est, le cas échéant, agencée au moyen de pièces insérées supplémentaires (80), de telle façon qu'une source de courant en place (70, 70') s'étende par son bord supérieur dans le creux formé dans la partie de paroi périphérique (30) prévue sur la partie supérieure (22) du boîtier.

0 072 417

*Fig.1*

*Fig.3*

**0 072 417**

*Fig. 4*

*Fig. 2*

2

Fig. 5

Fig. 6

Fig. 7

0 072 417

Fig. 8

Fig. 9

*Fig. 10*

Fig. 11

Fig. 12

_Fig. 13_

31    37'    14    36'

22

31

30

21

40    37'    48'    14    48a    26a

_Fig. 14_

38a    22

30

47'

36a

36'

46'

38'

31

48'

37a

37'

30

38a    21

8

*Fig. 15*

_Fig. 16_

_Fig. 17_

Fig. 18

0 072 417

Fig. 20

Fig. 19